# EUROPEAN PATENT APPLICATION

(11) **EP 4 604 168 A1**
(43) Date of publication of application: **20.08.2025**
(21) Application number: 24883545.6
(22) Date of filing: 11.11.2024

(54) **SOLAR CELL, AND PHOTOVOLTAIC MODULE AND MANUFACTURING METHOD THEREFOR**

(30) Priority: 16.04.2024 CN 202410461743
(71) Applicant: LONGi Green Energy Technology Co., Ltd., Xi'an, Shaanxi 710100 (CN)
(72) Inventor: CHEN, Weiqiang, Xi'an, Shaanxi 710100 (CN); YANG, Dongsheng, Xi'an, Shaanxi 710100 (CN); ZHANG, Huang, Xi'an, Shaanxi 710100 (CN); WANG, Xiaofei, Xi'an, Shaanxi 710100 (CN); CHEN, Jun, Xi'an, Shaanxi 710100 (CN); TONG, Hongbo, Xi'an, Shaanxi 710100 (CN)
(74) Representative: Grünecker Patent- und Rechtsanwälte PartG mbB
(86) International application number: PCT/CN2024/131370
(87) International publication number: WO 2025/130437

(57) **Abstract**

The present application discloses a solar cell, a photovoltaic module, and a manufacturing method therefor. The solar cell includes a solar cell substrate, collector electrodes, bus electrode sections, and first welding and/or soldering portions. The collector electrodes extend along a first direction, and are distributed at intervals along a second direction. The bus electrode sections are located in edge regions at two ends in the second direction, and extend along the second direction. The bus electrode sections are electrically coupled to corresponding ones of the collector electrodes having a same conductivity type as the bus electrode sections. The first welding and/or soldering portions are arranged on a side of corresponding ones of the bus electrode sections facing away from an edge of the solar cell substrate along the second direction, and are electrically coupled to the corresponding bus electrode sections.

## Description

### CROSS-REFERENCE TO RELATED APPLICATIONS

The present application claims priority and benefits to Chinese Patent Application No. 202410461743.2, filed on April 16, 2024, which is incorporated herein by reference in its entirety.

### TECHNICAL FIELD

The present application relates to the field of photovoltaic technologies, and in particular, to a solar cell, a photovoltaic module, and a manufacturing method therefor.

### BACKGROUND

At present, solar cells are increasingly widely used as a new energy alternative solution. A photovoltaic solar cell is an apparatus converting sun's light energy into electric energy. Specifically, the solar cell generates carriers by using the photovoltaic principle, and leads the carriers out by using electrodes, thereby facilitating the effective use of the electric energy.

However, after existing solar cells are connected in series by interconnectors to form a photovoltaic module together, soldering stresses of the interconnectors in edge regions of the solar cells are large, which is prone to a soldering failure.

### SUMMARY

An objective of the present application is to provide a solar cell, a photovoltaic module, and a manufacturing method therefor, to prevent soldering stresses of interconnectors in edge regions of solar cells from being large after a photovoltaic module is formed, thereby reducing a soldering failure risk.

To achieve the foregoing objective, according to a first aspect, the present application provides a solar cell. The solar cell includes a solar cell substrate, collector electrodes, bus electrode sections, and first welding and/or soldering portion. At least one of a light receiving surface and a side facing away from light of the solar cell substrate is a target surface. The collector electrodes and the bus electrode sections are arranged on the target surface of the solar cell substrate. The collector electrodes extend along a first direction. Different ones of the collector electrodes located on the same target surface are distributed at intervals along a second direction. The first direction is different from the second direction. The bus electrode sections are located in edge regions at two ends of the target surface along the second direction. The bus electrode sections extend along the second direction. The bus electrode sections are electrically coupled to some of the collector electrodes having a same conductivity type as the bus electrode sections. The first welding and/or soldering portion is arranged on a side of corresponding ones of the bus electrode sections facing away from an edge of the solar cell substrate along the second direction, and are electrically coupled to the corresponding bus electrode sections.

When the foregoing technical solution is used, the collector electrodes and the bus electrode sections included in the solar cell are arranged on the target surface of the solar cell substrate. In addition, the bus electrode sections are electrically coupled to some of the collector electrodes having a same conductivity type as the bus electrode sections. In this case, in a working state of the solar cell, carriers collected by the collector electrodes located in an edge region at one end of the target surface along the second direction are bussed to the bus electrode sections. In addition, the first welding and/or soldering portion included in the solar cell is arranged on a side of corresponding ones of the bus electrode sections facing away from an edge of the solar cell substrate along the second direction. Based on this, after a photovoltaic module is formed by connecting the solar cells, provided in the present application, in series by interconnectors, the interconnectors only need to be soldered together with the first welding and/or soldering portion, so that carriers collected by the collector electrodes in an edge region at one end of the target surface along the second direction can be collected, and ends of the interconnector do not need to extend to the edge regions at the two ends of the solar cell substrate along the second direction, to shorten an effective soldering length between the interconnectors and the solar cell substrate, thereby facilitating reducing soldering stresses in the edge regions of the solar cell substrate along the second direction, and further reducing a soldering failure risk. In addition, a requirement on soldering precision of a stringer machine can also be lowered, thereby reducing the difficulty in manufacturing the photovoltaic module. Further, ends of interconnectors connecting two adjacent solar cells in the photovoltaic module are prevented from overlapping and causing a short circuit.

Moreover, the bus electrode sections are located in edge regions at two ends of the target surface along the second direction. In other words, a length of a bus electrode section included in the solar cell provided in the present application is less than a length of a bus electrode included in a conventional busbar solar cell. Based on this, compared with a conventional busbar solar cell, in the solar cell provided in the present application, a total metal composite area between a collector electrode and a bus electrode section and a solar cell substrate is smaller, which helps the solar cell to have a higher open circuit voltage, and material consumption in manufacturing bus electrode sections can also be reduced, which helps to control manufacturing costs of the solar cell. In addition, it is defined that, in all the collector electrodes located on the same target surface, the collector electrodes electrically connected to the bus electrode sections are first-type collector electrodes, and the remaining collector electrodes are second-type collector electrodes. Based on this, when the solar cells provided in the present application are connected in series by interconnectors to form a photovoltaic module, the interconnectors can be electrically coupled to the second-type collector electrodes without passing through a bus electrode. In this case, a transmission path for transferring carriers collected by the second-type collector electrodes to the interconnectors is short, which is conducive to reducing a transmission loss and improving the working efficiency of a photovoltaic module formed by the solar cells provided in the present application.

In a possible implementation, a side of the first welding and/or soldering portions facing away from the bus electrode sections is not connected to the collector electrodes adjacent to the first soldering portions along the second direction and having a same conductivity type as the first welding and/or soldering portions. In this case, it is conducive to reducing a quantity of collector electrodes electrically coupled to the first welding and/or soldering portions, so that the carriers collected by the collector electrodes adjacent to a side of the first welding and/or soldering portions facing away from the bus electrode sections are directly transferred to the interconnectors, thereby helping to reduce a transmission loss of the carriers collected by the collector electrodes adjacent to the side of the first welding and/or soldering portions facing away from the bus electrode sections to the interconnectors.

In a possible implementation, different bus electrode sections located at a same end of the same target surface along the second direction are distributed at intervals along the first direction. The solar cell includes two of the bus electrode sections arranged oppositely at different ends of the same target surface along the second direction. The two bus electrode sections arranged oppositely are not connected. In this case, distribution of the different bus electrode sections on the target surface is regular, which helps to reduce difficulty in interconnecting adjacent solar cells. In addition, the two bus electrode sections that are arranged oppositely are not connected, which can ensure that a total length of the two bus electrode sections arranged oppositely along the second direction is less than a length of an entire bus electrode included in a conventional solar cell, and ensure that a metal composite loss between the bus electrode sections and the solar cell substrate is reduced, and a use amount of consumables in manufacturing the bus electrode sections is reduced. In addition, it is further conducive to ensuring that carriers collected by a collector electrode arranged between two bus electrode sections arranged oppositely have a low transmission loss.

In a possible implementation, a length of at least one of the bus electrode sections along the second direction is less than or equal to 10 mm.

When the foregoing technical solutions are used, a length of at least one of the bus electrode sections falls within the foregoing range, so that a large composite area between the bus electrode sections and the solar cell substrate caused by a large length of the bus electrode sections can be prevented, thereby ensuring a high open circuit voltage of the solar cell. In addition, it is also ensured that a use amount of consumables in manufacturing the bus electrode sections can be reduced, and a loss of transferring carriers collected by the collector electrodes to the interconnectors can be reduced.

In a possible implementation, a ratio of a length of at least one of the bus electrode sections to a width of the solar cell substrate along the second direction is less than or equal to 12%. For beneficial effects in this case, reference may be made to analysis on the beneficial effects of the foregoing description: a length of at least one of the bus electrode sections along the second direction is less than or equal to 10 mm. Details are not described herein again.

In a possible implementation, a width of at least one of the bus electrode sections along the first direction is greater than or equal to 10 µm and less than or equal to 500 µm.

When the foregoing technical solutions are used, a width of at least one of the bus electrode sections along the first direction falls within the foregoing range, so that a large transmission resistance caused by a small width of the bus electrode sections can be prevented, which is conducive to reducing a transmission loss of the bus electrode sections. In addition, a large metal composite area between the bus electrode sections and the solar cell substrate caused by a large width of the bus electrode sections can be prevented, thereby ensuring a high open circuit voltage of the solar cell. In addition, a use amount of consumables in manufacturing the bus electrode sections can be reduced. Further, when the solar cell provided in the present application is a back contact solar cell, that a width of at least one bus electrode section falls within the foregoing range can prevent a large width of the bus electrode sections from causing a large use amount of consumables for an insulation material arranged at intersections between collector electrodes located in edge regions at two ends of the target surface along the second direction and bus electrode sections having a conductivity type opposite to that of the collector electrodes. Alternatively, large spacings of discontinuities at intersections between collector electrodes located in edge regions at two ends of the target surface along the second direction and bus electrode sections having a conductivity type opposite to that of the collector electrodes can be prevented, thereby ensuring high efficiency of collecting carriers in the edge regions at the two ends of the target surface along the second direction.

In a possible implementation, a width of at least one of the bus electrode sections gradually increases along a direction of approaching the first welding and/or soldering portions. In this case, it is conducive to increasing a contact area between the bus electrode sections and the first welding and/or soldering portions, thereby reducing a transmission loss. In addition, stability of connections between the bus electrode sections and the first welding and/or soldering portions can also be improved, thereby improving the structural reliability of the solar cell.

In a possible implementation, a quantity of the bus electrode sections located at a same end of the same target surface along the second direction is greater than or equal to 6 and less than or equal to 30.

When the foregoing technical solution is used, if a quantity of the bus electrode sections located at a same end of the same target surface along the second direction falls within the foregoing range, it can be prevented that carriers can be collected to the bus electrode sections only after being transferred on the collector electrodes through a long path because the foregoing quantity is small, which is conducive to reducing a transmission loss of the collector electrodes and also conducive to reducing a risk that corresponding carriers cannot be transferred to the bus electrode sections after a collector electrode is broken. In addition, a large metal composite area between all the bus electrode sections located in the edge regions at the two ends of the target surface along the second direction and the solar cell substrate and at least a large use amount of consumables for all the bus electrode sections can also be prevented.

In a possible implementation, a ratio of a quantity of the collector electrodes located in an edge region at an end of the target surface along the second direction to a total quantity of all the collector electrodes located on the target surface is less than or equal to 12%. For beneficial effects in this case, reference may be made to analysis on the beneficial effects of the foregoing description: a quantity of the bus electrode sections located at a same end of the same target surface along the second direction is less than or equal to 30. Details are not described herein again.

In a possible implementation, the first welding and/or soldering portion and the bus electrode sections electrically coupled to the first welding and/or soldering portions are in an integrated structure.

When the foregoing technical solution is used, that the first welding and/or soldering portion and the bus electrode sections electrically coupled to the first welding and/or soldering portion are in an integrated structure means that the first welding and/or soldering portion and the bus electrode sections electrically coupled to the first welding and/or soldering portion are made of a same material and are manufactured and formed at the same time. Based on this, when the first welding and/or soldering portion and the bus electrode sections electrically coupled to the first welding and/or soldering portion are in an integrated structure, there is no gap at connections between the first welding and/or soldering portion and the bus electrode sections electrically coupled to the first welding and/or soldering portion, which is conducive to improving contact performance between the first welding and/or soldering portion and the bus electrode sections electrically coupled to the first welding and/or soldering portion, and reducing a transmission loss.

In a possible implementation, the solar cell further includes a first conductive material arranged on the first welding and/or soldering portion. In this case, in a process of connecting in series the solar cells provided in the present application to form a photovoltaic module, the interconnectors are soldered to the first welding and/or soldering portion by using a first conductive material, to ensure good soldering quality between the interconnectors and the first welding and/or soldering portion.

In a possible implementation, a length of the first welding and/or soldering portion along the first direction is greater than or equal to 100 µm and less than or equal to 10000 µm.

When the foregoing technical solution is used, a length of the first welding and/or soldering portions along the first direction falls within the foregoing range, which can prevent that placement positions of the interconnectors on the solar cells need to be strictly controlled during soldering because the length of the first welding and/or soldering portions is small, and prevent that the interconnectors are not soldered together with the first welding and/or soldering portions according to requirements because the interconnectors are offset, thereby improving the soldering yield. In addition, a large metal composite area between the first welding and/or soldering portions and the solar cell substrate and a large use amount of consumables in manufacturing the first welding and/or soldering portions that are caused by a large length of the first welding and/or soldering portions can also be prevented, thereby ensuring high working efficiency of the solar cell, and reducing manufacturing costs of the solar cell.

In a possible implementation, a width of the first welding and/or soldering portions along the second direction is greater than or equal to 100 µm and less than or equal to 10000 µm.

When the foregoing technical solution is used, a width of the first welding and/or soldering portions along the second direction falls within the foregoing range, which can prevent that a small width of the first welding and/or soldering portions from causing a small contact area between the first welding and/or soldering portions and the interconnectors, which is conducive to reducing the soldering resistance between the first welding and/or soldering portions and the interconnectors, is conducive to improving the soldering adhesion between the first welding and/or soldering portions and the interconnectors, and can also improve the structural reliability of the photovoltaic module formed based on the solar cells provided in the present application while reducing the transmission loss. In addition, a large composite area between the first welding and/or soldering portions and the solar cell substrate and a large use amount of consumables in manufacturing the first welding and/or soldering portions that are caused by a large width of the first welding and/or soldering portions can also be prevented, thereby ensuring high working efficiency of the solar cell, and reducing manufacturing costs of the solar cell.

In a possible implementation, in all the collector electrodes located on the same target surface, the collector electrodes electrically connected to the bus electrode sections are first-type collector electrodes, and the remaining collector electrodes are second-type collector electrodes. In addition, the solar cell further includes second welding and/or soldering portions. The second welding and/or soldering portions are electrically coupled to at least one of the second-type collector electrodes.

When the foregoing technical solution is used, the second welding and/or soldering portions included in the solar cell are electrically coupled to corresponding ones of the second-type collector electrodes, and the second welding and/or soldering portions correspond to at least one of the second-type collector electrodes. In this case, when the solar cells provided in the present application are connected in series by interconnectors to form a photovoltaic module, the interconnectors can be soldered together with the second-type collector electrodes through the second welding and/or soldering portions. Compared with implementing electrical connections to the interconnectors in a manner of arranging portions of the second-type collector electrodes located along directions in which the first welding and/or soldering portions having a same conductivity type as the second-type collector electrodes extend along the second direction as miniature widened electrode sections, a contact area between the second welding and/or soldering portions and the interconnectors is larger, which is conducive to reducing the soldering resistance between the interconnectors and the second-type collector electrodes and improving the soldering adhesion between the interconnectors and the second-type collector electrodes.

In a possible implementation, at least some of the second welding and/or soldering portions are arranged in parallel along the second direction. In this case, it is conducive to regularly distributing the second welding and/or soldering portions in the second direction, to avoid a high requirement on arrangement precision of making the interconnectors and different second welding and/or soldering portions in contact by the automatic stringer machine due to disorderly distribution of the different second welding and/or soldering portions, thereby helping to reduce difficulty in interconnecting adjacent solar cells by the interconnectors.

In a possible implementation, center lines of at least some of the second welding and/or soldering portions along the second direction are colinear with a center line of at least one of the bus electrode sections along the second direction. In this case, along the second direction, center lines of at least some of the second welding and/or soldering portions and a center line of at least one of the bus electrode sections are on a same extension line, which is conducive to preventing staggered distribution of the center lines of the two along the second direction from causing a high requirement on arrangement precision of making the interconnectors respectively in contact the second welding and/or soldering portions and the first welding and/or soldering portions electrically coupled to the bus electrode sections by the automatic stringer machine, thereby helping to reduce difficulty in interconnecting adjacent solar cells by the interconnectors.

In a possible implementation, at least some of the second welding and/or soldering portions are arranged in parallel along the second direction. A gap is provided between one of the second welding and/or soldering portions and an adjacent another of the second welding and/or soldering portions along the second direction. At least one of the collector electrodes is disconnected at the gap, or at least one of the collector electrodes continuously passes the gap. In this case, after adjacent solar cells are interconnected together by the interconnectors, the interconnectors are electrically isolated from the collector electrodes having an opposite conductivity type by spacings at which the collector electrodes are disconnected at the gaps, and no insulation material, such as an insulation compound, needs to be arranged, which is conducive to reducing costs of interconnecting the solar cells, and is also conducive to reducing difficulty in arranging the insulation material at the gaps.

In a possible implementation, a length of the second welding and/or soldering portions along the first direction is greater than or equal to 100 µm and less than or equal to 10000 µm. Beneficial effects in this case are similar to the beneficial effects of the foregoing description: a length of the first welding and/or soldering portions along the first direction is greater than or equal to 100 µm and less than or equal to 10000 µm. Details are not described herein again.

In a possible implementation, a width of the second welding and/or soldering portions along the second direction is greater than or equal to 100 µm and less than or equal to 500 µm. Beneficial effects in this case are similar to the beneficial effects of the foregoing description: a width of the first welding and/or soldering portions along the second direction is greater than or equal to 500 µm and less than or equal to 10000 µm. In addition, when the solar cell provided in the present application is a back contact solar cell, a width of the second welding and/or soldering portions along the second direction falls within the foregoing range, which can prevent a large width of a second connection portion from causing overlapping between an end of the second connection portion and a collector electrode adjacent to the second connection portion and having an opposite conductivity type and causing a short circuit, thereby ensuring high electrical reliability of the solar cell.

In a possible implementation, a width of the first welding and/or soldering portions is greater than or equal to a width of the second welding and/or soldering portions. In this case, a large contact area between the first welding and/or soldering portions and the interconnectors can be ensured, which helps to lower the soldering resistance between the first welding and/or soldering portions and the interconnectors and helps to improve the soldering adhesion between the first welding and/or soldering portions and the interconnectors. In addition, a large metal composite area between the second welding and/or soldering portions and the solar cell substrate caused by a large width of the second welding and/or soldering portions can be prevented, thereby ensuring high working reliability of the solar cell.

In a possible implementation, a length of the first welding and/or soldering portions is equal to a length of the second welding and/or soldering portions.

When the foregoing technical solution is used, a length of the first welding and/or soldering portions and a length of the second welding and/or soldering portions affect sizes of effective contact with the interconnectors along the first direction. In addition, during actual manufacturing, due to a problem of device precision, placement positions of the interconnectors on the solar cell are offset. Therefore, along the first direction, when a length of the first welding and/or soldering portions is equal to a length of the second welding and/or soldering portions, sizes of effective contact between the first welding and/or soldering portions and the interconnectors and between the second welding and/or soldering portions and the interconnectors along the first direction are approximately the same, thereby ensuring good contact between the interconnectors and the first welding and/or soldering portions and between the interconnectors and the second welding and/or soldering portions.

In a possible implementation, the solar cell further includes a second conductive material arranged on the second welding and/or soldering portions. For beneficial effects in this case, reference may be made to analysis on the beneficial effects of the foregoing description: the solar cell further includes a first conductive material. Details are not described herein again.

In a possible implementation, spacings between ends of adjacent ones of the bus electrode sections with opposite conductivity types close to an edge of the solar cell substrate and the edge of the solar cell substrate are not equal. In this case, collector electrodes with opposite conductivity types are alternately distributed at intervals along the second direction. In this case, along the second direction, spacings between two collector electrodes with opposite conductivity types close to an edge of the solar cell substrate and the edge of the solar cell substrate are different. Based on this, when spacings between ends of adjacent ones of the bus electrode sections with opposite conductivity types close to an edge of the solar cell substrate and the edge of the solar cell substrate are not equal, a spacing between an end of each bus electrode section close to the edge of the solar cell substrate and the edge of the solar cell substrate is set based on a conductivity type of the bus electrode section, to ensure that the bus electrode sections can export carriers collected by corresponding collector electrodes, and further help to reduce a spacing between an end of a bus electrode section close to an edge of the solar cell substrate and a collector electrode having a same conductivity type as the bus electrode section, thereby reducing a risk of electric leakage. In addition, a metal composite loss between the bus electrode sections and the solar cell substrate is also reduced.

In a possible implementation, edges of a plurality of ones of the first welding and/or soldering portions close to a side of the bus electrode sections are flush or not flush. In this case, when edges of a plurality of ones of the first welding and/or soldering portions close to a side of the bus electrode sections are flush, it is conducive to enabling different first welding and/or soldering portions facing away from a side of the solar cell substrate to have a same surface area, and further conducive to enabling a large contact area between each first welding and/or soldering portion and the interconnector, thereby ensuring good electrical contact performance and stable mechanical connection performance between the first welding and/or soldering portions and the interconnectors. In addition, for beneficial effects obtained when edges of a plurality of ones of the first welding and/or soldering portions close to a side of the bus electrode sections are not flush, reference may be made to analysis on the beneficial effects of the foregoing description: spacings between ends of adjacent ones of the bus electrode sections with opposite conductivity types close to an edge of the solar cell substrate and the edge of the solar cell substrate are not equal. Details are not described herein again.

In a possible implementation, lengths of a plurality of ones of the bus electrode sections are equal or not equal. For beneficial effects in this case, reference may be made to analysis on the beneficial effects of the foregoing description: edges of a plurality of ones of the first welding and/or soldering portions close to a side of the bus electrode sections are flush or not flush. Details are not described herein again.

In a possible implementation, the solar cell further includes an edge bus electrode. The edge bus electrode is arranged at an end of the solar cell substrate along the first direction and extends along the second direction. A maximum width of the edge bus electrode is less than a maximum width of the bus electrode sections. In this case, existence of the edge bus electrode facilitates exporting carriers collected of edge portions of the collector electrodes along the first direction, to prevent a failure in exporting the carriers due to a break in the edge portions of the collector electrodes along the first direction. Alternatively, a problem that the carriers collected by the edge portions of the collector electrodes along the first direction cannot be exported or can hardly be exported because the collector electrodes are disconnected at intersections between the collector electrodes and the interconnectors having an opposite conductivity type to the collector electrodes, thereby reducing the power loss of the solar cell. In addition, a maximum width of the edge bus electrode is less than a maximum width of the bus electrode sections, which is conducive to reducing the metal composite loss between the edge bus electrode and the solar cell substrate, and reducing difficulty and a use amount of consumables in manufacturing the edge bus electrode in an edge region of the solar cell substrate along the first direction.

In a possible implementation, the edge bus electrode is electrically coupled to at least some of the collector electrodes having a same conductivity type as the edge bus electrode. Ends, along the first direction, of the collector electrodes electrically coupled to the edge bus electrode exceed the edge bus electrode. In this case, it is ensured that the edge portions of the collector electrodes along the first direction can be electrically coupled to the edge bus electrode, and it is ensured that the carriers collected by the edge portions of the collector electrodes along the first direction can be exported through the edge bus electrode.

In a possible implementation, the solar cell further includes a voltage test point. The voltage test point is arranged on the bus electrode sections. In this case, a width of the bus electrode sections is large. Therefore, arranging a voltage test point on the bus electrode sections can reduce difficulty of a test probe in coming into contact with a corresponding electrode, thereby ensuring accuracy of a test result. In addition, it is further conducive to preventing a short circuit problem when the solar cell is a back contact solar cell.

In a possible implementation, a distance by which an end of at least one of the bus electrode sections located at an edge of the solar cell substrate exceeds the collector electrodes electrically coupled to the at least one of the bus electrode sections and located at the edge of the solar cell substrate is greater than 0 mm and less than 0.12 mm. In the foregoing case, a problem that a large value of the distance causes a small distance between an end of the bus electrode section close to an edge region of the target surface along the second direction and an end of the solar cell substrate, which is prone to overlapping and a short-circuit of bus electrode sections after two adjacent solar cells are connected in series, can be prevented. In addition, a large risk of electric leakage caused by a small distance between an end of the bus electrode section close to an edge region of the target surface along the second direction and a collector electrode having an opposite conductivity type to the bus electrode section and located on an outermost side of the edge region of the target surface along the second direction can be further prevented, thereby ensuring high electrical reliability of the back contact solar cell.

In a possible implementation, the target surface is the back surface. In all the bus electrode sections located at a same end of the back surface along the second direction, two of the bus electrode sections located outermost along the first direction are first-type bus electrode sections, and the remaining bus electrode sections are second-type bus electrode sections. The first-type bus electrode sections are located on an outer side of an end of corresponding ones of the collector electrodes close to the solar cell substrate along the first direction. The solar cell further includes connection electrode sections. The first-type bus electrode sections are electrically coupled to corresponding ones of the first welding and/or soldering portions by the connection electrode sections.

When the foregoing technical solution is used, the first-type bus electrode section is arranged on an outer side of an end of a corresponding collector electrode close to the solar cell substrate along the first direction, and the first-type bus electrode section is electrically coupled to the corresponding first welding and/or soldering portion by a connection electrode section. In this case, a collector electrode located in an edge region of the back surface along the second direction does not need to be electrically isolated from a first-type bus electrode section having an opposite conductivity type to the collector electrode by arranging a discontinuity, thereby ensuring that all carriers collected by portions of the collector electrode located in the edge region of the back surface along the second direction can be transferred to a corresponding bus electrode section, thereby improving the carrier collection efficiency.

In a possible implementation, the foregoing solar cell is a back contact solar cell. The target surface is only a side facing away from light of the solar cell substrate. In this case, at least some of the collector electrodes located in the edge regions at the two ends of the target surface along the second direction are non-continuous collector electrodes. The non-continuous collector electrodes have a discontinuity for spacing apart the second-type bus electrode sections having a conductivity type opposite to that of the non-continuous collector electrodes. Two ends of the non-continuous collector electrodes along the first direction are spaced apart by the first-type bus electrode sections having a conductivity type opposite to that of the non-continuous collector electrode.

In a possible implementation, the collector electrodes not electrically coupled to the bus electrode sections are disconnected and arranged at a portion between two corresponding ones of the first welding and/or soldering portions arranged oppositely. In this case, a short circuit can be prevented, and the electrical reliability of the back contact solar cell can be improved.

In a possible implementation, in all the collector electrodes located in the edge regions at the two ends of the target surface along the second direction, the collector electrodes located on an outer side are continuous collector electrodes, and the remaining collector electrodes are non-continuous collector electrodes.

When the foregoing technical solution is used, during an actual application, a portion of a bus electrode section close to an edge region of the target surface along the second direction extends to a collector electrode having an opposite conductivity type to the bus electrode section and located at an edge. In this case, a collector electrode located at an edge is set as a continuous collector electrode, to increase carrier collection efficiency of the collector electrode located at the edge while preventing a short circuit, thereby ensuring a small carrier recombination rate in the edge region of the target surface along the second direction.

In a possible implementation, the non-continuous collector electrodes include a plurality of collector electrode sections distributed at intervals along the first direction. In addition, when a width of at least one of the bus electrode sections gradually increases along a direction of approaching the first welding and/or soldering portions, corresponding different pairs of the collector electrode sections having a conductivity type opposite to that of the same bus electrode section correspond to different spacings. The pairs of the collector electrode sections each are two adjacent ones of the collector electrode sections included by the same collector electrode.

When the foregoing technical solution is used, when a width of at least one of the bus electrode sections gradually increases along a direction of approaching the first welding and/or soldering portions, corresponding different pairs of the collector electrode sections having a conductivity type opposite to that of the same bus electrode section correspond to different spacings, to prevent a small spacing between a corresponding pair of collector electrode sections corresponding to a same bus electrode section with a large width from causing a large risk of electric leakage, and also prevent a large spacing between a corresponding pair of collector electrode sections corresponding to a same bus electrode section with a small width from causing a poor carrier collection capability thereof, thereby helping to improve working performance of the back contact solar cell.

In a possible implementation, an end of at least one of the bus electrode sections close to an edge region of the target surface along the second direction extends to a side, close to the edge region of the target surface along the second direction, of a corresponding one of the collector electrodes electrically coupled to the bus electrode section. In this case, it can be ensured that a bus electrode section can be electrically coupled to a collector electrode having a same conductivity type as the bus electrode section and located on an outermost side in an edge region of the target surface along the second direction, and it can be ensured that carriers collected by the collector electrode located at on the outermost side in the edge region of the target surface along the second direction can be exported.

In a possible implementation, an end of the bus electrode sections close to the first welding and/or soldering portions is flush with an end of the first welding and/or soldering portions close to the bus electrode sections. Alternatively, an end of the bus electrode sections close to the first welding and/or soldering portions extends to a portion on a side of the first welding and/or soldering portions facing away from the solar cell substrate. In this case, there are the foregoing two arrangement solutions for an end of a bus electrode section close to a first welding and/or soldering portion, to reduce difficulty in manufacturing the bus electrode section while ensuring that the bus electrode section can be electrically coupled to the corresponding first welding and/or soldering portion, and ensuring that carriers collected by the bus electrode section can be exported through the first welding and/or soldering portion.

According to a second aspect, the present application provides a photovoltaic module. The photovoltaic module includes: the solar cells according to the foregoing first aspect and various implementations thereof, and interconnectors configured to connect adjacent ones of the solar cells in series. The interconnectors are soldered to the first welding and/or soldering portions. Terminals of the interconnectors exceed the first welding and/or soldering portions.

In a possible implementation, a ratio of a length by which the interconnectors exceed the first welding and/or soldering portions to a length of the bus electrode sections is greater than or equal to 5% and less than or equal to 20%.

When the foregoing technical solution is used, a ratio of a length by which an interconnector exceeds a first welding and/or soldering portion to a length of the bus electrode section falls within the foregoing range, which can prevent a small contact area between two ends of the interconnector along the second direction and the first welding and/or soldering portions due to a small value of the ratio, and ensure that the interconnector can come into contact with regions of a surface on a side of the first welding and/or soldering portion facing away from the solar cell substrate, thereby causing a small contact resistance between the two. In addition, carriers collected by collector electrodes between first welding and/or soldering portions and an edge of the solar cell substrate are conducted to the interconnectors through bus electrode sections and the first welding and/or soldering portions. Therefore, if the ratio falls within the foregoing range, it is further conducive to preventing a large value of the ratio from causing a large length of a portion that the interconnector does not need to extend and causing a large use amount of consumables. In addition, when the interconnector is in contact with the bus electrode section, it is further conducive to preventing a large value of the ratio from causing a large interconnection stress between the interconnector and the bus electrode section, thereby improving a yield of the solar cell.

In a possible implementation, a length by which the interconnectors exceed the first welding and/or soldering portions is less than or equal to 2 mm.

In a possible implementation, the interconnectors and the bus electrode sections are in contact with each other or have gaps.

According to a third aspect, the present application provides a manufacturing method for a photovoltaic module. The manufacturing method for a photovoltaic module includes: first, providing the solar cells according to the foregoing first aspect and various implementations thereof; and then, connecting adjacent ones of the solar cells together in series by interconnectors using an infrared soldering process.

For beneficial effects of the second aspect and various implementations of the second aspect and the third aspect and various implementations of the third aspect in the present application, reference may be made to the analysis of the beneficial effects of the first aspect and various implementations of the first aspect, and details are not described herein again.

### BRIEF DESCRIPTION OF THE DRAWINGS

The accompanying drawings described herein are used to provide a further understanding of the present application, and form a part of the present application. Some exemplary embodiments of the present application and description thereof are used to explain the present application, and do not constitute any inappropriate limitation to the present application. In the accompanying drawings:
FIG. 1 is a schematic diagram of a distribution of an electrode structure of a busbar solar cell in the related art;
FIG. 2 is a schematic diagram of a distribution of an electrode structure of a busbar-free solar cell in the related art;
FIG. 3 is a schematic top view 1 of a structure on a side of a back surface of a solar cell according to an embodiment of the present application when the solar cell is a back contact solar cell;
FIG. 4 is a schematic top view 2 of a structure on a side of a back surface of a solar cell according to an embodiment of the present application when the solar cell is a back contact solar cell;
FIG. 5 is a schematic enlarged view 1 of a partial structure on a side of a back surface of a solar cell according to an embodiment of the present application when the solar cell is a back contact solar cell;
FIG. 6 is a schematic enlarged view 2 of a partial structure on a side of a back surface of a solar cell according to an embodiment of the present application when the solar cell is a back contact solar cell;
FIG. 7 is a schematic enlarged view 3 of a partial structure on a side of a back surface of a solar cell according to an embodiment of the present application when the solar cell is a back contact solar cell; and
FIG. 8 is a schematic diagram of a structure according to an embodiment of the present application after solar cells are connected in series by interconnectors to form a photovoltaic module.

Reference numerals: 11 is a solar cell substrate, 12 is a collector electrode, 13 is a bus electrode section, 14 is a first welding and/or soldering portion, 15 is a first-type collector electrode, 16 is a second-type collector electrode, 17 is a second welding and/or soldering portion, 18 is a first-type bus electrode section, 19 is a second-type bus electrode section, 20 is a connection electrode section, 21 is a first end, 22 is a second end, 23 is an interconnector, 24 is a bus electrode, and 25 is an edge bus electrode.

### DETAILED DESCRIPTION

Some embodiments of the present disclosure are described below with reference to the accompanying drawings. However, it should be understood that, the description is merely exemplary, and is not intended to limit the scope of the present disclosure. In addition, in the following description, description of well-known structures and technologies are omitted, to avoid unnecessarily obscuring the concept of the present disclosure.

The accompanying drawings show various schematic structural diagrams according to some embodiments of the present disclosure. The accompanying drawings are not drawn to scale, some details are enlarged for the purpose of clarity, and some details may be omitted. Shapes of various regions and layers shown in the drawings, and relative sizes and positional relationships between the various regions and layers are merely exemplary, and may deviate in practice due to manufacturing tolerances or technical limitations, and a person skilled in the art may additionally design regions/layers with different shapes, sizes, and relative positions according to actual requirements.

In the context of the present disclosure, when a layer/element is referred to as being "on" another layer/element, the layer/element may be directly on the another layer/element, or an intermediate layer/element may exist between the layer/element and the another layer/element. In addition, if one layer/element is "above" another layer/element in an orientation, when the orientation is turned, the layer/element may be "below" the another layer/element. To make the technical problems to be resolved by, the technical solutions, and the beneficial effects of the present application clearer and more comprehensible, the following further describes the present application in detail with reference to the accompanying drawings and some embodiments. It should be understood that, the specific embodiments described herein are merely used for describing the present application and are not used for limiting the present application.

In addition, the terms "first" and "second" are used for descriptive purposes only and are not to be construed as indicating or implying relative importance or implicitly indicating the number of technical features indicated. Therefore, a feature defined by "first" or "second" may explicitly indicate or implicitly include one or more features. In the description of the present application, "a plurality of" means two or more, unless otherwise definitely and specifically limited. "Several" means one or more, unless otherwise definitely and specifically limited.

In the description of the present application, it should be noted that, unless otherwise explicitly specified or defined, the terms such as "install", "connect", and "connection" should be understood in a broad sense. For example, the connection may be a fixed connection, a detachable connection, or an integral connection; or the connection may be a mechanical connection or an electrical connection; or the connection may be a direct connection, an indirect connection through an intermediary, internal communication between two elements, or an interactive relationship between two elements. A person of ordinary skill in the art can understand specific meanings of the terms in the present application based on specific situations.

At present, solar cells are increasingly widely used as a new energy alternative solution. A photovoltaic solar cell is an apparatus converting sun's light energy into electric energy. In an actual working process, the solar cell generates carriers by using the photovoltaic principle, and leads the carriers out by using electrodes, thereby facilitating the effective use of the electric energy.

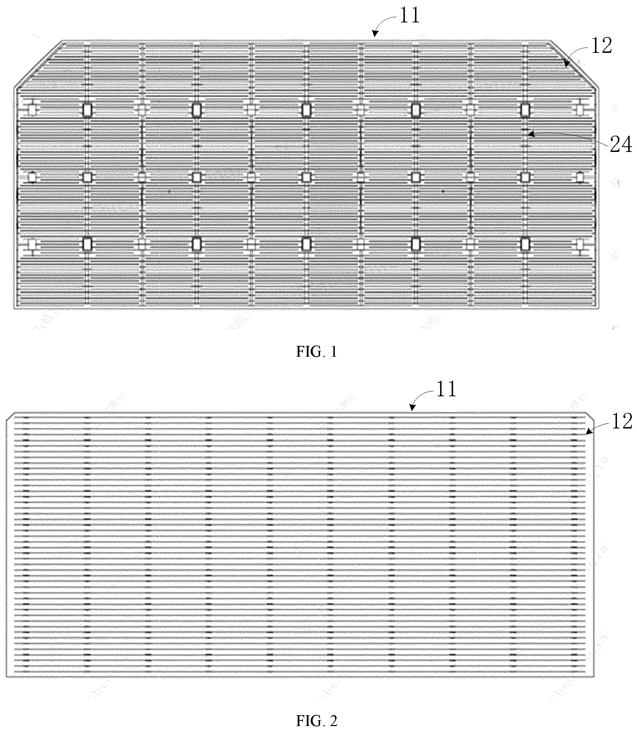

In an actual application process, according to different electrode structures of solar cells, the solar cells are classified into a busbar solar cell and a busbar-free solar cell. An electrode structure of the busbar solar cell includes a plurality of collector electrodes and at least one bus electrode. Different collector electrodes extend along a first direction, and are distributed at intervals along a second direction. The bus electrode extends along the second direction, and is electrically coupled to a collector electrode having a same conductivity type as the bus electrode. As shown in FIG. 1, when the busbar solar cell is a back contact solar cell, a collector electrode 12 is disconnected at an intersection with a bus electrode 24 having a conductivity type opposite to the collector electrode 12, to prevent electric leakage. Alternatively, a collector electrode 12 is isolated by an insulation material from a bus electrode 24 having a conductivity type opposite to the collector electrode 12. Based on this, for the busbar solar cell, because carriers collected by the collector electrode 12 can be collected at a connection portion only by passing through the bus electrode 24, resulting in a longer transmission path of the carriers, and an increased transmission loss of the carriers passing through the bus electrode 24. Then, arrangement of the bus electrode 24 increases a composite area between an electrode structure and a solar cell substrate 11, resulting in a lowered open circuit voltage of the solar cell. In addition, formation of the bus electrode 24 further needs to consume a large amount of electrode material, which is not conducive to reducing manufacturing costs of the solar cell.

As shown in FIG. 2, an electrode structure of a busbar-free solar cell does not include the foregoing bus electrode. In addition, a collector electrode 12 included in the busbar-free solar cell has widened electrode sections in some regions along a first direction, to be soldered together with interconnectors through the widened electrode sections. Based on this, although a metal composite area between the electrode structure included in the busbar-free solar cell and a solar cell substrate 11 is small, a soldering contact area between the widened electrode sections and the interconnectors is also small, resulting in a large soldering resistance and a small soldering adhesion. Then, to export all carriers collected by all collector electrodes 12, the interconnectors need to be soldered together with the widened electrode sections of all the collector electrodes 12. In addition, after a photovoltaic module is formed through soldering, the interconnector has a specific length, and the interconnector and the solar cell substrate 11 have different deformation degrees after soldering heating and cooling. Therefore, a soldering stress at an edge of the solar cell substrate 11 after soldering is large, which is prone a soldering failure problem. In addition, along a second direction, a spacing between a collector electrode 12 on an outer side and the edge of the solar cell substrate 11 is small, which is prone to disconnection from a collector electrode 12 at the edge during soldering, and also leads to a high requirement on precision of a stringer machine, resulting in high difficulty in manufacturing a photovoltaic module.

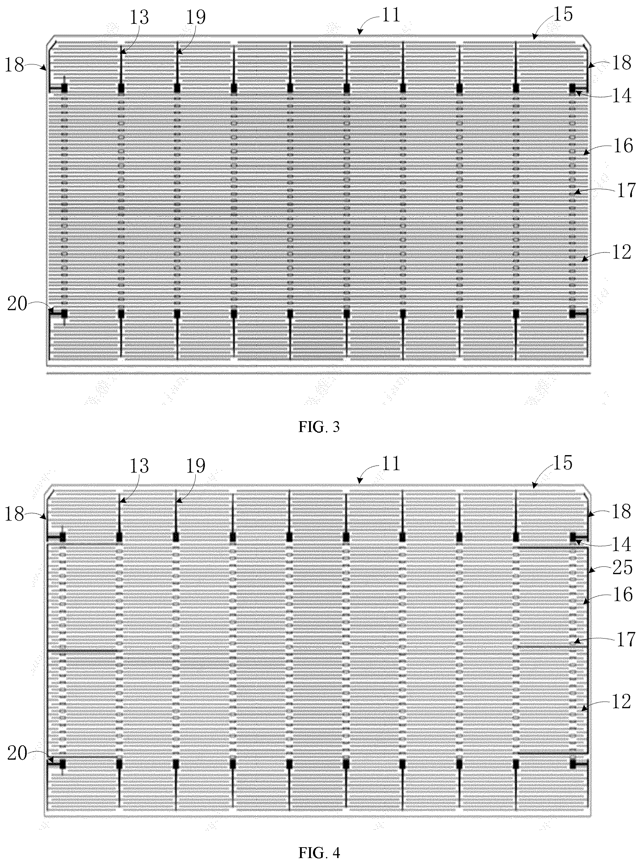

To resolve the foregoing technical problems, according to a first aspect, an embodiment of the present application provides a solar cell. Specifically, in terms of distribution positions of electrodes, the solar cell provided in some embodiments of the present application is a double-sided contact solar cell, that is, one of a positive electrode and a negative electrode of the solar cell is located on a side of a light receiving surface of the solar cell substrate 11, and the other is located on a side of a side facing away from light of the solar cell substrate 11. Alternatively, as shown in FIG. 3 to FIG. 6, the solar cell provided in some embodiments of the present application is a back contact solar cell, that is, both a positive electrode and a negative electrode of the solar cell are located on a side of a side facing away from light of the solar cell substrate 11.

In addition, in terms of division, the solar cell provided in some embodiments of the present application is a full solar cell. Alternatively, as shown in FIG. 3 to FIG. 6, the solar cell provided in some embodiments of the present application is a cut solar cell. A cutting multiple of the foregoing cut solar cell is not specifically limited in some embodiments of the present application. For example, the foregoing cut solar cell is a half-cut solar cell, a triple-cut solar cell, or a quarter-cut solar cell.

As shown in FIG. 3 to FIG. 6, the solar cell provided in some embodiments of the present application includes: a solar cell substrate 11, collector electrodes 12, bus electrode sections 13, and first welding and/or soldering portions 14. At least one of a light receiving surface and a side facing away from light of the solar cell substrate 11 is a target surface. The collector electrodes 12 and the bus electrode sections 13 are arranged on the target surface of the solar cell substrate 11. The collector electrodes 12 extend along a first direction, and different ones of the collector electrodes 12 located on the same target surface are distributed at intervals along a second direction. The first direction is different from the second direction. The bus electrode sections 13 are located in edge regions at two ends of the target surface along the second direction, and the bus electrode sections 13 extend along the second direction. The bus electrode sections 13 are electrically coupled to some of the collector electrodes 12 having a same conductivity type as the bus electrode sections 13. The first welding and/or soldering portions 14 are arranged on a side of corresponding ones of the bus electrode sections 13 facing away from an edge of the solar cell substrate 11 along the second direction, and are electrically coupled to the corresponding bus electrode sections 13.

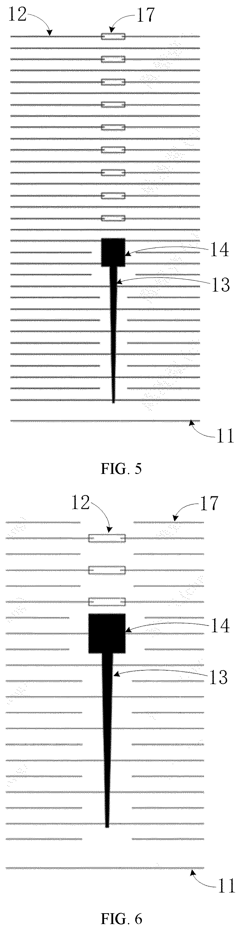

When the foregoing technical solution is used, as shown in FIG. 3 and FIG. 6, the collector electrodes 12 and the bus electrode sections 13 included in the solar cell are arranged on the target surface of the solar cell substrate 11. In addition, the bus electrode sections 13 are electrically coupled to some of the collector electrodes 12 having a same conductivity type as the bus electrode sections 13. In this case, in a working state of the solar cell, carriers collected by the collector electrodes 12 located in an edge region at one end of the target surface along the second direction are bussed to the bus electrode sections 13. In addition, the first welding and/or soldering portions 14 included in the solar cell are arranged on a side of corresponding ones of the bus electrode sections 13 facing away from an edge of the solar cell substrate 11 along the second direction. Based on this, as shown in FIG. 3, FIG. 4, and FIG. 8, after a photovoltaic module is formed by connecting the solar cells, provided in some embodiments of the present application, in series by interconnectors 23, the interconnectors 23 only need to be soldered together with the first welding and/or soldering portions 14, so that carriers collected by the collector electrodes 12 in an edge region at one end of the target surface along the second direction can be collected, and ends of the interconnector 23 do not need to extend to the edge regions at the two ends of the solar cell substrate 11 along the second direction, to shorten an effective soldering length between the interconnectors 23 and the solar cell substrate 11, thereby facilitating reducing soldering stresses in the edge regions of the solar cell substrate 11 along the second direction, and further reducing a soldering failure risk. In addition, a requirement on soldering precision of a stringer machine can also be lowered, thereby reducing the difficulty in manufacturing the photovoltaic module. Further, ends of interconnectors 23 connecting two adjacent solar cells in the photovoltaic module are prevented from overlapping and causing a short circuit. Moreover, as shown in FIG. 3 to FIG. 6, the bus electrode sections 13 are located in edge regions at two ends of the target surface along the second direction. In other words, a length of a bus electrode section 13 included in the solar cell provided in some embodiments of the present application is less than a length of a bus electrode included in a conventional busbar solar cell. Based on this, compared with a conventional busbar solar cell, in the solar cell provided in some embodiments of the present application, a total metal composite area between a collector electrode 12 and a bus electrode section 13 and a solar cell substrate 11 is smaller, which helps the solar cell to have a higher open circuit voltage, and material consumption in manufacturing bus electrode sections 13 can also be reduced, which helps to control manufacturing costs of the solar cell. In addition, it is defined that, in all the collector electrodes 12 located on the same target surface, the collector electrodes 12 electrically connected to the bus electrode sections 13 are first-type collector electrodes 15, and the remaining collector electrodes 12 are second-type collector electrodes 16. Based on this, when the solar cells provided in some embodiments of the present application are connected in series by interconnectors to form a photovoltaic module, the interconnectors can be electrically coupled to the second-type collector electrodes 16 without passing through a bus electrode. In this case, a transmission path for transferring carriers collected by the second-type collector electrodes 16 to the interconnectors is short, which is conducive to reducing a transmission loss and improving the working efficiency of a photovoltaic module formed by the solar cells provided in some embodiments of the present application.

During an actual application, in some embodiments of the present application, a structure and a material of the solar cell substrate, and whether the light receiving surface and the back surface that are of the solar cell substrate are target surfaces are not specifically limited, and are determined based on a type of the solar cell and an actual application scenario. This is not specifically limited herein.

For example, when the solar cell provided in some embodiments of the present application is a double-sided contact solar cell, the solar cell substrate includes a semiconductor substrate and a doped semiconductor layer formed on a side of a light receiving surface or a back surface of the semiconductor substrate. A conductivity type of the doped semiconductor layer is opposite to a conductivity type of the semiconductor substrate. In the foregoing case, only the light receiving surface of the solar cell substrate is the target surface, only the side facing away from light of the solar cell substrate is the target surface, or both the light receiving surface and the side facing away from light of the solar cell substrate are target surfaces.

Specifically, a material of the foregoing semiconductor layer is a semiconductor material such as silicon, silicon germanium, germanium, or gallium arsenide. The conductivity type of the semiconductor substrate is N-type, or is P-type. For the doped semiconductor layer, when the conductivity type of the semiconductor substrate is N-type, the conductivity type of the doped semiconductor layer is P-type. When the conductivity type of the semiconductor substrate is P-type, the conductivity type of the doped semiconductor layer is N-type. A material of the doped semiconductor layer is a semiconductor material such as silicon, germanium, silicon carbide or gallium arsenide. **In** terms of an internal arrangement form of substances, the doped semiconductor layer is amorphous, microcrystalline, monocrystalline, nanocrystalline, polycrystalline, or the like.

In another example, when the solar cell provided in some embodiments of the present application is a back contact solar cell, a semiconductor base includes a semiconductor substrate and a doped semiconductor layer formed in or on some regions of a back surface of the semiconductor substrate. A conductivity type of the doped semiconductor layer is opposite to a conductivity type of the semiconductor substrate. In this case, in an actual process of manufacturing a semiconductor base, it only needs to form an entire doped semiconductor layer covering a side of a back surface of a semiconductor substrate, and remove a portion of the doped semiconductor layer located on the side of the back surface, so that two doped regions having opposite conductivity types can be formed on the side of the back surface, thereby resolving a problem of a complex manufacturing process of a solar cell due to a need of doping the back surface twice with opposite conductivity types.

Specifically, when the semiconductor base includes the foregoing semiconductor substrate and the doped semiconductor layer formed on some regions of the back surface of the semiconductor substrate, for materials and conductivity types of the semiconductor substrate and the doped semiconductor layer, reference may be made to the foregoing materials and conductivity types of the semiconductor substrate and the doped semiconductor layer that are included in the semiconductor base when the solar cell is a double-sided contact solar cell, and details are not described herein again.

In some cases, the foregoing semiconductor base further includes a passivation layer located between the semiconductor substrate and the doped semiconductor layer. The passivation layer passivates at least portions of a surface of the semiconductor substrate in contact with the doped semiconductor layer, and reduce a carrier recombination rate at contact between the semiconductor substrate and the doped semiconductor layer. In addition, the doped semiconductor layer formed on the passivation layer can achieve selective collection of carriers of corresponding conductivity types in the semiconductor substrate, to further improve the photoelectric conversion efficiency of the solar cell provided in some embodiments of the present application. Specifically, a material of the passivation layer is determined based on a material of the doped semiconductor layer.

For example, when the doped semiconductor layer is a doped amorphous silicon layer, a doped microcrystalline silicon layer, or a hybrid layer of doped amorphous silicon and microcrystalline silicon, the passivation layer is an intrinsic amorphous silicon layer, an intrinsic microcrystalline silicon layer, or a hybrid layer of intrinsic amorphous silicon and microcrystalline silicon. In this case, the doped semiconductor layer and the passivation layer form a heterocontact structure.

For example, when the doped semiconductor layer is a doped polysilicon layer, the passivation layer is a tunneling passivation layer. In this case, the doped semiconductor layer and the passivation layer form a tunneling passivation contact structure. In addition, a material of the tunneling passivation layer includes any dielectric material having a tunneling passivation effect. For example, a material of the tunneling passivation layer includes one or more of silicon oxide, aluminum oxide, titanium oxide, hafnium oxide, gallium oxide, titanium pentoxide, niobium pentoxide, silicon nitride, silicon carbonitride, aluminum nitride, titanium nitride, and titanium carbonitride.

In the foregoing case, when the solar cell provided in some embodiments of the present application is a back contact solar cell, only the side facing away from light of the solar cell substrate is the target surface, and the collector electrodes, the bus electrode sections, and the first welding and/or soldering portions are located on only a side of the side facing away from light of the solar cell substrate.

For the foregoing collector electrodes, the shapes, quantity, and distribution of the collector electrodes are not specifically limited in some embodiments of the present application, and are determined based on the type of the solar cell and an actual application scenario.

For example, when the solar cell provided in some embodiments of the present application is a double-sided contact solar cell, different collector electrodes located on a same target surface have a same conductivity type. In addition, the collector electrode is a continuous collector electrode, or is a non-continuous collector electrode.

In another example, as shown in FIG. 3 to FIG. 6, when the solar cell provided in some embodiments of the present application is a back contact solar cell, it is defined that, in all the bus electrode sections 13 located at a same end of the back surface along the second direction, two of the bus electrode sections 13 located outermost along the first direction are first-type bus electrode sections 18, and the remaining bus electrode sections 13 are second-type bus electrode sections 19. Based on this, the foregoing first-type collector electrode 15 is a continuous collector electrode. In this case, the first-type collector electrode 15 is spaced, by an insulation material, apart from a bus electrode section 13 having a conductivity type opposite to that of the first-type collector electrode 15, to prevent a short circuit.

Alternatively, as shown in FIG. 3 to FIG. 6, at least some of the first-type collector electrodes 15 are non-continuous collector electrodes. In addition, the first-type bus electrode sections 18 are located on an outer side of an end of corresponding ones of the collector electrodes 12 close to the solar cell substrate along the first direction, the solar cell further includes connection electrode sections 20, and the first-type bus electrode sections 18 are electrically coupled to corresponding ones of the first welding and/or soldering portions 14 by the connection electrode sections 20. In this case, the non-continuous collector electrodes have a discontinuity for spacing apart the second-type bus electrode sections 19 having a conductivity type opposite to that of the non-continuous collector electrodes, and two ends of the non-continuous collector electrodes along the first direction are spaced apart by the first-type bus electrode sections 18 having a conductivity type opposite to that of the non-continuous collector electrodes. In this case, the first-type bus electrode section 18 is arranged on an outer side of an end of a corresponding collector electrode 12 close to the solar cell substrate along the first direction, and the first-type bus electrode section 18 is electrically coupled to the corresponding first welding and/or soldering portion 14 by a connection electrode section 20. In this case, a collector electrode 12 located in an edge region of the back surface along the second direction does not need to be electrically isolated from a first-type bus electrode section 18 having an opposite conductivity type to the collector electrode by arranging a discontinuity, thereby ensuring that all carriers collected by portions of the collector electrode 12 located in the edge region of the back surface along the second direction can be transferred to a corresponding bus electrode section, thereby improving the carrier collection efficiency.

Specifically, a size of a discontinuity of a non-continuous collector electrode and a shape of the connection electrode section are not specifically limited in some embodiments of the present application, provided that they can be applied to the solar cell provided in some embodiments of the present application. Each first-type collector electrode is a non-continuous collector electrode. Alternatively, in all the collector electrodes located in the edge regions at the two ends of the target surface along the second direction, the collector electrodes located on an outer side are continuous collector electrodes, and the remaining collector electrodes are non-continuous collector electrodes. In this case, during an actual application, a portion of a bus electrode section close to an edge region of the target surface along the second direction extends to a collector electrode having an opposite conductivity type to the bus electrode section and located at an edge. In this case, a collector electrode located at an edge is set as a continuous collector electrode, to increase carrier collection efficiency of the collector electrode located at the edge while preventing a short circuit, thereby ensuring a small carrier recombination rate in the edge region of the target surface along the second direction.

For the foregoing second-type collector electrode, as shown in FIG. 3 and FIG. 5, the second-type collector electrode 16 is a continuous collector electrode. In this case, the foregoing solar cell further includes an insulation material (not shown in the figure). The insulation material is arranged on a portion of the collector electrode 12 (that is, the second-type collector electrode 16) not electrically coupled to the bus electrode section 13 and located between two corresponding first welding and/or soldering portions 14 arranged oppositely. Alternatively, as shown in FIG. 4 and FIG. 6, the second-type collector electrode 16 is a non-continuous collector electrode. In other words, the collector electrodes 12 not electrically coupled to the bus electrode sections 13 are disconnected and arranged at a portion between two corresponding ones of the first welding and/or soldering portions 14 arranged oppositely. In the foregoing case, through arrangement of an insulation material or disconnection, the interconnector is spaced apart from the first-type collector electrode 15 (the collector electrode 12 not electrically coupled to the bus electrode section 13) having an opposite conductivity type, to prevent a short circuit.

A type and a size of the foregoing insulation material are determined based on an actual application scenario, and are not specifically limited herein. For example, the insulation material is an insulation compound.

For example, along the first direction, a length of the insulation material is greater than or equal to 1 mm and less than or equal to 5 mm. For example, the length of the insulation material is 1 mm, 2 mm, 3 mm, 4 mm, 5 mm, or the like. In this case, that the length of the insulation material falls within the foregoing range along the first direction can prevent a small length of the insulation material from making it difficult to isolate an interconnector from a collector electrode having an opposite conductivity type to the interconnector by the insulation material, thereby preventing a short circuit. In addition, a large use amount of consumables corresponding to the insulation material caused by a large length of the insulation material can be prevented, which is conducive to controlling manufacturing costs of the solar cell.

For example, along the second direction, a width of the insulation material is greater than or equal to 1 mm and less than or equal to 10 mm. For example, the width of the insulation material is 1 mm, 2 mm, 4 mm, 6 mm, 8 mm, 10 mm, or the like. In this case, that the width of the insulation material falls within the foregoing range along the second direction can prevent a small width of the insulation material from causing the insulation material to fail to completely cover corresponding portions of a first-type collector electrode and making it difficult to isolate an interconnector from a collector electrode having an opposite conductivity type to the interconnector by the insulation material, thereby preventing a short circuit. In addition, it can also be prevented that a large width of the insulation material causes the insulation material to cover some regions of a collector electrode (or a second welding and/or soldering portion) adjacent to the insulation material and causes a small contact area between the collector electrode (or the second welding and/or soldering portion) and an interconnector.

In addition, the foregoing second-type collector electrode has widened electrode sections, to be soldered together with interconnectors through the widened electrode sections. Along the second direction, the widened electrode sections of the foregoing second-type collector electrode are arranged between two opposite first welding and/or soldering portions having a same conductivity type as the collector electrode.

Alternatively, as shown in FIG. 3 to FIG. 6, the foregoing solar cell further includes second welding and/or soldering portions 17. The second welding and/or soldering portions 17 are electrically coupled to corresponding ones of the second-type collector electrodes 16. The second welding and/or soldering portion 17 is located between two first welding and/or soldering portions 14 having a same conductivity type as the second welding and/or soldering portion 17 and arranged oppositely. The second welding and/or soldering portions 17 are electrically coupled to at least one of the second-type collector electrodes 16. In this case, the second welding and/or soldering portions 17 included in the solar cell are electrically coupled to corresponding ones of the second-type collector electrodes 16, and the second welding and/or soldering portions 17 correspond to at least one of the second-type collector electrodes 16. In this case, when the solar cells provided in some embodiments of the present application are connected in series by interconnectors to form a photovoltaic module, the interconnectors can be soldered together with the second-type collector electrodes 16 through the second welding and/or soldering portions 17. Compared with implementing electrical connections to the interconnectors in a manner of arranging portions of the second-type collector electrodes 16 located along directions in which the first welding and/or soldering portions 14 having a same conductivity type as the second-type collector electrodes extend along the second direction as miniature widened electrode sections, a contact area between the second welding and/or soldering portions 17 and the interconnectors is larger, which is conducive to reducing the soldering resistance between the interconnectors and the second-type collector electrodes 16 and improving the soldering adhesion between the interconnectors and the second-type collector electrodes 16.

Specifically, a size and a shape of the second welding and/or soldering portions are not specifically limited in some embodiments of the present application, provided that they can be applied to the solar cell provided in some embodiments of the present application.

For example, a length of the second welding and/or soldering portions along the first direction is greater than or equal to 100 µm and less than or equal to 10000 µm. For example, a length of the second welding and/or soldering portions is 100 µm, 500 µm, 1000 µm, 3000 µm, 6000 µm, 9000 µm, 10000 µm, or the like. In this case, a width of the second welding and/or soldering portions along the first direction falls within the foregoing range, which can prevent that placement positions of the interconnectors on the solar cells need to be strictly controlled during soldering because the width of the second welding and/or soldering portions is small, and prevent that the interconnectors are not soldered together with the second welding and/or soldering portions according to requirements because the interconnectors are offset, thereby improving the soldering yield. In addition, a large composite area between the second welding and/or soldering portions and the solar cell substrate and a large use amount of consumables in manufacturing the second welding and/or soldering portions that are caused by a large width of the second welding and/or soldering portions can also be prevented, thereby ensuring high working efficiency of the solar cell, and reducing manufacturing costs of the solar cell.

For example, a width of the second welding and/or soldering portions along the second direction is greater than or equal to 100 µm and less than or equal to 500 µm. For example, a width of the second welding and/or soldering portions is 100 µm, 200 µm, 300 µm, 400 µm, 500 µm, or the like. In this case, a length of the second welding and/or soldering portions along the second direction falls within the foregoing range, which can prevent that a small length of the second welding and/or soldering portions from causing a small contact area between the second welding and/or soldering portions and the interconnectors, which is conducive to reducing the soldering resistance between the second welding and/or soldering portions and the interconnectors, is conducive to improving the soldering adhesion between the second welding and/or soldering portions and the interconnectors, and can also improve the structural reliability of the photovoltaic module formed based on the solar cells provided in some embodiments of the present application while reducing the transmission loss. In addition, a large composite area between the second welding and/or soldering portions and the solar cell substrate and a large use amount of consumables in manufacturing the second welding and/or soldering portions that are caused by a large length of the second welding and/or soldering portions can also be prevented, thereby ensuring high working efficiency of the solar cell, and reducing manufacturing costs of the solar cell. In addition, as shown in FIG. 3 to FIG. 6, when the solar cell provided in the present application is a back contact solar cell, a width of the second welding and/or soldering portions 17 along the second direction falls within the foregoing range, which can prevent a large width of a second welding and/or soldering portion 17 from causing overlapping between an end of the second welding and/or soldering portion and a collector electrode 12 adjacent to the second welding and/or soldering portion 17 and having an opposite conductivity type and causing a short circuit, thereby ensuring high electrical reliability of the solar cell.

As described above, when the solar cell provided in some embodiments of the present application further includes an insulation material arranged on the second-type collector electrodes, a length of the insulation material along the first direction is equal to a length of the second welding and/or soldering portion. Alternatively, a length of the insulation material is greater than a length of the second welding and/or soldering portion. In this case, it can be prevented an interconnector overlaps a collector electrode having a conductivity type opposite to that of the interconnector because a placement position of the interconnector on the solar cell is offset, thereby preventing a short circuit.

Specifically, when the length of the insulation material is greater than the length of the second welding and/or soldering portion, a difference between the length of the insulation material and the length of the second welding and/or soldering portion is determined based on precision of the stringer machine for forming the photovoltaic module and an actual application scenario. This is not specifically limited herein.

In addition, in some cases, the solar cell further includes a second conductive material arranged on the second welding and/or soldering portions. In this case, in a process of connecting in series the solar cells provided in some embodiments of the present application to form a photovoltaic module, the interconnectors are soldered to the second welding and/or soldering portions by using a second conductive material, to ensure good soldering quality between the interconnectors and the second welding and/or soldering portions. Specifically, the second conductive material is a conductive material such as a conductive compound, tin, or silver.

For a distribution of different second welding and/or soldering portions, as shown in FIG. 3 to FIG. 6, at least some of the second welding and/or soldering portions 17 are arranged in parallel along the second direction. Alternatively, different second welding and/or soldering portions are distributed in a staggered manner along the second direction. When at least some of the second welding and/or soldering portions 17 are arranged in parallel along the second direction, it is conducive to regularly distributing the second welding and/or soldering portions 17 in the second direction, to avoid a high requirement on arrangement precision of making the interconnectors and different second welding and/or soldering portions 17 in contact by the automatic stringer machine due to disorderly distribution of the different second welding and/or soldering portions 17, thereby helping to reduce difficulty in interconnecting adjacent solar cells by the interconnectors.

Secondly, as shown in FIG. 3 to FIG. 6, center lines of at least some of the second welding and/or soldering portions 17 along the second direction are colinear with a center line of at least one of the bus electrode sections 13 along the second direction. Alternatively, center lines of at least some of the second welding and/or soldering portions along the second direction are not collinear with a center line of at least one of the bus electrode sections along the second direction, but center lines of at least some of the second welding and/or soldering portions along the second direction are approximately parallel to a center line of at least one of the bus electrode sections 13 along the second direction. Alternatively, center lines of at least some of the second welding and/or soldering portions along the second direction are arranged obliquely with respect to a center line of at least one of the bus electrode sections along the second direction. When center lines of at least some of the second welding and/or soldering portions 17 along the second direction are colinear with a center line of at least one of the bus electrode sections 13 along the second direction, along the second direction, center lines of at least some of the second welding and/or soldering portions 17 and a center line of at least one of the bus electrode sections 13 are on a same extension line, which is conducive to preventing staggered distribution of the center lines of the two along the second direction from causing a high requirement on arrangement precision of making the interconnectors respectively in contact the second welding and/or soldering portions 17 and the first welding and/or soldering portions 14 electrically coupled to the bus electrode sections 13 by the automatic stringer machine, thereby helping to reduce difficulty in interconnecting adjacent solar cells by the interconnectors.

In addition, as shown FIG. 3 to FIG. 6, at least some of the second welding and/or soldering portions 17 are arranged in parallel along the second direction, and there is a gap between one of the second welding and/or soldering portions 17 and an adjacent another of the second welding and/or soldering portions 17 along the second direction. In this case, at least one of the collector electrodes 12 is disconnected at the gap, or at least one of the collector electrodes 12 continuously passes the gap. In this case, after adjacent solar cells are interconnected together by the interconnectors, the interconnectors are electrically isolated from the collector electrodes 12 having an opposite conductivity type by spacings at which the collector electrodes 12 are disconnected at the gaps, and no insulation material, such as an insulation compound, needs to be arranged, which is conducive to reducing costs of interconnecting the solar cells, and is also conducive to reducing difficulty in arranging the insulation material at the gaps. A size of a gap between one of the second welding and/or soldering portions 17 and an adjacent another of the second welding and/or soldering portions 17 is determined based on a spacing between adjacent collector electrodes 12 and a size of the second welding and/or soldering portion 17. This is not specifically limited herein. In addition, a spacing at which at least one of the collector electrodes 12 is disconnected at a gap is set according to an actual application scenario, provided that it can be applied to the solar cell provided in some embodiments of the present application.

For the foregoing bus electrode sections, a shape and a quantity of the bus electrode sections are not specifically limited in some embodiments of the present application, provided that carriers collected by collector electrodes located on edges at two ends of the target surface along the second direction can be transferred to the first welding and/or soldering portions through the bus electrode sections.

For example, along the first direction, a width of at least one of the bus electrode sections is less than or equal to 500 µm. For example, a width of at least one of the bus electrode sections is 10 µm, 50 µm, 100 µm, 200 µm, 300 µm, 400 µm, 500 µm, or the like. In this case, along the first direction, a width of at least one of the bus electrode sections falls within the foregoing range, so that a large metal composite area between the bus electrode sections and the solar cell substrate caused by a large width of the bus electrode sections can be prevented, thereby ensuring a high open circuit voltage of the solar cell. In addition, a use amount of consumables in manufacturing the bus electrode sections can be reduced. Further, when the solar cell provided in some embodiments of the present application is a back contact solar cell, that a width of at least one bus electrode section falls within the foregoing range can prevent a large width of the bus electrode sections from causing a large use amount of consumables for an insulation material arranged at intersections between collector electrodes located in edge regions at two ends of the target surface along the second direction and bus electrode sections having a conductivity type opposite to that of the collector electrodes. Alternatively, large spacings of discontinuities at intersections between collector electrodes located in edge regions at two ends of the target surface along the second direction and bus electrode sections having a conductivity type opposite to that of the collector electrodes can be prevented, thereby ensuring high efficiency of collecting carriers in the edge regions at the two ends of the target surface along the second direction.

Specifically, widths of portions of the foregoing bus electrode section along the second direction are the same or different. A width relationship between portions of the bus electrode section along the second direction is determined based on a requirement on a shape of the bus electrode section in an actual application scenario.

For example, a width of at least one of the bus electrode sections gradually increases along a direction of approaching the first welding and/or soldering portions. In this case, it is conducive to increasing a contact area between the bus electrode sections and the first welding and/or soldering portions, thereby reducing a transmission loss. In addition, stability of connections between the bus electrode sections and the first welding and/or soldering portions can also be improved, thereby improving the structural reliability of the solar cell. Specifically, a width of the bus electrode section increases in a linear or parabolic manner in a direction of approaching the first welding and/or soldering portions.

When the solar cell provided in some embodiments of the present application is a back contact solar cell, as described above, at least some of the collector electrodes located in the edge regions at the two ends of the target surface along the second direction are non-continuous collector electrodes. The non-continuous collector electrodes include a plurality of collector electrode sections distributed at intervals along the first direction. In addition, when a width of at least one of the bus electrode sections gradually increases along a direction of approaching the first welding and/or soldering portions, corresponding different pairs of the collector electrode sections having a conductivity type opposite to that of the same bus electrode section correspond to a same spacing or different spacings. The pairs of the collector electrode sections each are two adjacent ones of the collector electrode sections included by the same collector electrode. When corresponding different pairs of the collector electrode sections having a conductivity type opposite to that of the same bus electrode section correspond to different spacings, a small spacing between a corresponding pair of collector electrode sections corresponding to a same bus electrode section with a large width from causing a large risk of electric leakage can be prevented, and a large spacing between a corresponding pair of collector electrode sections corresponding to a same bus electrode section with a small width from causing a poor carrier collection capability thereof can also be prevented, thereby helping to improve working performance of the back contact solar cell.

Specifically, when a width of at least one of the bus electrode sections gradually increases along a direction of approaching the first welding and/or soldering portions, spacings corresponding to corresponding different pairs of the collector electrode sections having a conductivity type opposite to that of the same bus electrode section are determined based on widths of different regions of the bus electrode section and a requirement on electric leakage prevention in an actual application scenario, and are not specifically limited herein.

For a specific shape of the bus electrode section, for example, a cross-sectional shape of the bus electrode section is a shape such as a rectangle, a trapezoid, an ellipse, or a rhombus.

In addition, it may be understood that, within a particular range, a larger length of the bus electrode sections indicates a larger quantity of electrical couplings between the bus electrode sections and the collector electrodes, and a larger distance between a corresponding end of the interconnector connecting different solar cells in series and an edge region at an end of the solar cell substrate along the second direction indicates a smaller soldering stress. However, a larger length of the bus electrode sections indicates a larger composite area between the bus electrode sections and the solar cell substrate, a larger use amount of consumables corresponding to the bus electrode sections, and a larger loss of transferring carriers collected by the collector electrodes located in the edge region of the target surface along the second direction to the interconnector. Based on this, a length of the bus electrode sections and a ratio of a length of the bus electrode sections to a width of the solar cell substrate is determined based on the foregoing requirements on the soldering stress, composite area, transmission loss, and the like in an actual application scenario.

For example, a length of at least one of the bus electrode sections along the second direction is less than or equal to 10 mm. For example, a length of at least one of the bus electrode sections along the second direction is greater than or equal to 1 mm and less than or equal to 7 mm. For example, a length of at least one of the bus electrode sections along the second direction is 1 mm, 2 mm, 4 mm, 6 mm, 8 mm, 10 mm, or the like. In this case, when the foregoing technical solutions are used, a length of at least one of the bus electrode sections falls within the foregoing range, so that a large metal composite area between the bus electrode sections and the solar cell substrate caused by a large length of the bus electrode sections can be prevented, thereby ensuring a high open circuit voltage of the solar cell. In addition, it is also ensured that a use amount of consumables in manufacturing the bus electrode sections can be reduced, and a loss of transferring carriers collected by the collector electrodes to the interconnectors can be reduced.

For example, a ratio of a length of at least one of the bus electrode sections to a width of the solar cell substrate along the second direction is less than or equal to 12%. For example, a ratio of a length of at least one of the bus electrode sections to a width of the solar cell substrate is 4.5%, 5%, 7%, 9%, 10%, 12%, or the like. For beneficial effects in this case, reference may be made to analysis on the beneficial effects of the foregoing description: a length of at least one of the bus electrode sections along the second direction is less than or equal to 10 mm. Details are not described herein again.

Specifically, lengths of a plurality of bus electrode sections are equal, or lengths of a plurality of bus electrode sections are not equal. When the lengths of the plurality of bus electrode sections are equal, it is conducive to reducing a pattern complexity degree of the electrode structure of the solar cell, and reducing difficulty in manufacturing the electrode structure. In addition, collector electrodes with opposite conductivity types are alternately distributed at intervals along the second direction. In this case, along the second direction, spacings between two collector electrodes with opposite conductivity types close to an edge of the solar cell substrate and the edge of the solar cell substrate are different. Based on this, when lengths of the plurality of bus electrode sections are not equal, a length of each bus electrode section can be set is set based on a conductivity type of the bus electrode section, to ensure that the bus electrode sections can export carriers collected by corresponding collector electrodes, and further help to reduce a spacing between an end of a bus electrode section close to an edge of the solar cell substrate and a collector electrode having a same conductivity type as the bus electrode section, thereby reducing a risk of electric leakage. In addition, a metal composite loss between the bus electrode sections and the solar cell substrate is also reduced.

In addition, spacings between ends of adjacent ones of the bus electrode sections with opposite conductivity types close to an edge of the solar cell substrate and the edge of the solar cell substrate are not equal or equal. For beneficial effects obtained when spacings between ends of adjacent ones of the bus electrode sections with opposite conductivity types close to an edge of the solar cell substrate and the edge of the solar cell substrate are not equal, reference may be made to analysis on the beneficial effects obtained when lengths of a plurality of bus electrode sections are not equal as described above. Details are not described herein again.

An end of at least one of the bus electrode sections close to an edge region of the target surface along the second direction just comes into contact with a corresponding one of the collector electrodes electrically coupled to the bus electrode section. Alternatively, an end of at least one of the bus electrode sections close to an edge region of the target surface along the second direction extends to a side, close to the edge region of the target surface along the second direction, of a corresponding one of the collector electrodes electrically coupled to the bus electrode section. In this case, it can be ensured that a bus electrode section can be electrically coupled to a collector electrode having a same conductivity type as the bus electrode section and located on an outermost side in an edge region of the target surface along the second direction, and it can be ensured that carriers collected by the collector electrode located at on the outermost side in the edge region of the target surface along the second direction can be exported.

With regard to an end of the bus electrode sections close to the first welding and/or soldering portions, the end of the bus electrode sections close to the first welding and/or soldering portions is flush with an end of the first welding and/or soldering portions close to the bus electrode sections. Alternatively, the end of the bus electrode sections close to the first welding and/or soldering portions extends to a portion on a side of the first welding and/or soldering portions facing away from the solar cell substrate. In this case, there are the foregoing two arrangement solutions for an end of a bus electrode section close to a first welding and/or soldering portion, to reduce difficulty in manufacturing the bus electrode section while ensuring that the bus electrode section can be electrically coupled to the corresponding first welding and/or soldering portion, and ensuring that carriers collected by the bus electrode section can be exported through the first welding and/or soldering portion.

Specifically, a distance by which an end of at least one of the bus electrode sections close to an edge region of the target surface along the second direction extends to a side, close to the edge region of the target surface along the second direction, of a corresponding one of the collector electrodes electrically coupled to the bus electrode section and a length by which an end of the bus electrode sections close to the first welding and/or soldering portions extends to a portion on a side of the first welding and/or soldering portions facing away from the solar cell substrate are determined based on actual manufacturing precision and an actual requirement, and are not specifically limited herein.

For example, a distance by which an end of at least one of the bus electrode sections located at an edge of the solar cell substrate exceeds the collector electrodes electrically coupled to the at least one of the bus electrode sections and located at the edge of the solar cell substrate is greater than 0 mm and less than 0.12 mm. For example, a distance by which an end of at least one of the bus electrode sections located at an edge of the solar cell substrate exceeds the collector electrodes electrically coupled to the at least one of the bus electrode sections and located at the edge of the solar cell substrate is 0.02 mm, 0.04 mm, 0.06 mm, 0.08 mm, 0.1 mm, 0.11 mm, or the like. In the foregoing case, a problem that a large value of the distance causes a small distance between an end of the bus electrode section close to an edge region of the target surface along the second direction and an end of the solar cell substrate, which is prone to overlapping and a short-circuit of bus electrode sections after two adjacent solar cells are connected in series, can be prevented. In addition, a large risk of electric leakage caused by a small distance between an end of the bus electrode section close to an edge region of the target surface along the second direction and a collector electrode having an opposite conductivity type to the bus electrode section and located on an outermost side of the edge region of the target surface along the second direction can be further prevented, thereby ensuring high electrical reliability of the back contact solar cell.

In addition, a length of the bus electrode sections also affects a quantity of collector electrodes located on in an edge region at an end of the target surface along the second direction. Based on this, a quantity of collector electrodes in an edge region at an end of the target surface along the second direction and a ratio of a quantity of the collector electrodes located in an edge region at an end of the target surface along the second direction to a total quantity of all the collector electrodes located on the target surface are determined based on a length of the bus electrode sections, a spacing between the collector electrodes, and a width of the collector electrodes.

For example, a ratio of a quantity of the collector electrodes located in an edge region at an end of the target surface along the second direction to a total quantity of all the collector electrodes located on the target surface is less than or equal to 12%. For example, a ratio of a quantity of the collector electrodes located in an edge region at an end of the target surface along the second direction to a total quantity of all the collector electrodes located on the target surface is 4.5%, 5%, 7%, 9%, 10%, 12%, or the like. For beneficial effects in this case, reference may be made to analysis on the beneficial effects of the foregoing description: a quantity of the bus electrode sections located at a same end of the same target surface along the second direction is less than or equal to 30. Details are not described herein again.

With regard to a quantity of the bus electrode sections, because the quantity of the bus electrode sections affects a length of a transmission path of carriers in a corresponding region of the collector electrodes and affects a composite area between the bus electrode sections and the solar cell substrate, the quantity of the bus electrode sections is determined based on requirements on a transmission loss and a composite area in an actual application scenario.

For example, a quantity of the bus electrode sections located on a same side of the same target surface along the second direction is greater than or equal to 6 and less than or equal to 30. For example, a quantity of the bus electrode sections located on a same side of the same target surface along the second direction is 6, 8, 10, 15, 20, 25, 30, or the like. In this case, if a quantity of the bus electrode sections located at a same end of the same target surface along the second direction falls within the foregoing range, it can be prevented that carriers can be collected to the bus electrode sections only after being transferred on the collector electrodes through a long path because the foregoing quantity is small, which is conducive to reducing a transmission loss and also conducive to reducing a risk that corresponding carriers cannot be transferred to the bus electrode sections after a collector electrode is broken. **In** addition, a large composite area between all the bus electrode sections located in the edge regions at the two ends of the target surface along the second direction and the solar cell substrate and at least a large use amount of consumables for all the bus electrode sections can also be prevented.

With regard to a distribution of the bus electrode sections, as shown in FIG. 3 to FIG. 6, different ones of the bus electrode sections 13 located at a same end of the same target surface along the second direction are distributed at intervals along the first direction, and the solar cell includes two of the bus electrode sections 13 arranged oppositely at different ends of the same target surface along the second direction. Moreover, the two bus electrode sections 13 arranged oppositely are not connected. In this case, distribution of the different bus electrode sections 13 on the target surface is regular, which helps to reduce difficulty in interconnecting adjacent solar cells. In addition, the two bus electrode sections 13 that are arranged oppositely are not connected, which can ensure that a total length of the two bus electrode sections 13 arranged oppositely along the second direction is less than a length of an entire bus electrode included in a conventional solar cell, and ensure that a metal composite loss between the bus electrode sections 13 and the solar cell substrate 11 is reduced, and a use amount of consumables in manufacturing the bus electrode sections 13 is reduced. In addition, it is further conducive to ensuring that carriers collected by a collector electrode 12 arranged between two bus electrode sections 13 arranged oppositely have a low transmission loss.

In an example, the foregoing solar cell further includes a voltage test point, and the voltage test point is arranged on the bus electrode sections. In this case, a width of the bus electrode sections is large. Therefore, arranging a voltage test point on the bus electrode sections can reduce difficulty of a test probe in coming into contact with a corresponding electrode, thereby ensuring accuracy of a test result. In addition, it is further conducive to preventing a short circuit problem when the solar cell is a back contact solar cell. Specifically, a specific location of the voltage test point on the bus electrode sections is determined based on an actual requirement. For example, the voltage test point is arranged at an intersection between a bus electrode section and a collector electrode.

In an example, as shown in FIG. 4, the foregoing solar cell further includes an edge bus electrode 25. The edge bus electrode 25 is arranged at an end of the solar cell substrate 11 along the first direction and extends along the second direction. In addition, a maximum width of the edge bus electrode 25 is less than a maximum width of the bus electrode sections 13. In this case, existence of the edge bus electrode 25 facilitates exporting carriers collected of edge portions of the collector electrodes 12 along the first direction, to prevent a failure in exporting the carriers due to a break in the edge portions of the collector electrodes 12 along the first direction. Alternatively, a problem that the carriers collected by the edge portions of the collector electrodes 12 along the first direction cannot be exported or can hardly be exported because the collector electrodes 12 are disconnected at intersections between the collector electrodes and the interconnectors having an opposite conductivity type to the collector electrodes, thereby reducing the power loss of the solar cell. In addition, a maximum width of the edge bus electrode 25 is less than a maximum width of the bus electrode sections 13, which is conducive to reducing the metal composite loss between the edge bus electrode 25 and the solar cell substrate 11, and reducing difficulty and a use amount of consumables in manufacturing the edge bus electrode 25 in an edge region of the solar cell substrate 11 along the first direction.

Specifically, a width of the edge bus electrode is determined based on an actual application scenario, which is not specifically limited herein. In addition, when the edge bus electrode is electrically coupled to at least some of the collector electrodes having a same conductivity type as the edge bus electrode, ends, along the first direction, of the collector electrodes electrically coupled to the edge bus electrode just come into contact with the edge bus electrode. Alternatively, ends, along the first direction, of the collector electrodes electrically coupled to the edge bus electrode exceed the edge bus electrode. In this case, it is ensured that the edge portions of the collector electrodes along the first direction can be electrically coupled to the edge bus electrode, and it is ensured that the carriers collected by the edge portions of the collector electrodes along the first direction can be exported through the edge bus electrode.

For the foregoing first welding and/or soldering portions, at least one of the first welding and/or soldering portions and the bus electrode sections electrically coupled to the first welding and/or soldering portion are in a non-integrated structure. Alternatively, at least one of the first welding and/or soldering portions and the bus electrode sections electrically coupled to the first welding and/or soldering portion are in an integrated structure. That at least one of the first welding and/or soldering portions and the bus electrode sections electrically coupled to the first welding and/or soldering portion are in an integrated structure means that the at least one of the first welding and/or soldering portions and the bus electrode sections electrically coupled to the first welding and/or soldering portion are made of a same material and are manufactured and formed at the same time. Based on this, when at least one of the first welding and/or soldering portions and the bus electrode sections electrically coupled to the first welding and/or soldering portion are in an integrated structure, there is no gap at a connection between the at least one of the first welding and/or soldering portions and the bus electrode sections electrically coupled to the first welding and/or soldering portion, which is conducive to improving contact performance between the first welding and/or soldering portion and the bus electrode section electrically coupled to the first welding and/or soldering portion, and reducing a transmission loss.

A size of the first welding and/or soldering portions is determined based on requirements for a soldering resistance and a soldering adhesion between the interconnector and the first welding and/or soldering portion and a composite area between the first welding and/or soldering portion and the solar cell substrate in an actual application scenario.

For example, a length of the first welding and/or soldering portions along the first direction is greater than or equal to 100 µm and less than or equal to 10000 µm. For example, a length of the first welding and/or soldering portions is 100 µm, 500 µm, 1000 µm, 3000 µm, 6000 µm, 9000 µm, 10000 µm, or the like. In this case, a length of the first welding and/or soldering portions along the first direction falls within the foregoing range, which can prevent that placement positions of the interconnectors on the solar cells need to be strictly controlled during soldering because the length of the first welding and/or soldering portions is small, and prevent that the interconnectors are not soldered together with the first welding and/or soldering portions according to requirements because the interconnectors are offset, thereby improving the soldering yield. In addition, a large composite area between the first welding and/or soldering portions and the solar cell substrate and a large use amount of consumables in manufacturing the first welding and/or soldering portions that are caused by a large length of the first welding and/or soldering portions can also be prevented, thereby ensuring high working efficiency of the solar cell, and reducing manufacturing costs of the solar cell.

For example, a width of the first welding and/or soldering portions along the second direction is greater than or equal to 100 µm and less than or equal to 10000 µm. For example, a width of the first welding and/or soldering portions is 100 µm, 1000 µm, 3000 µm, 6000 µm, 9000 µm, 10000 µm, or the like. In this case, a width of the first welding and/or soldering portions along the second direction falls within the foregoing range, which can prevent that a small width of the first welding and/or soldering portions from causing a small contact area between the first welding and/or soldering portions and the interconnectors, which is conducive to reducing the soldering resistance between the first welding and/or soldering portions and the interconnectors, is conducive to improving the soldering adhesion between the first welding and/or soldering portions and the interconnectors, and can also improve the structural reliability of the photovoltaic module formed based on the solar cells provided in some embodiments of the present application while reducing the transmission loss. In addition, a large composite area between the first welding and/or soldering portions and the solar cell substrate and a large use amount of consumables in manufacturing the first welding and/or soldering portions that are caused by a large width of the first welding and/or soldering portions can also be prevented, thereby ensuring high working efficiency of the solar cell, and reducing manufacturing costs of the solar cell.

Specifically, a width of the first welding and/or soldering portions is equal to a width of the second welding and/or soldering portions. Alternatively, as shown in FIG. 3 to FIG. 6, a width of the first welding and/or soldering portions 14 may be greater than a width of the second welding and/or soldering portions 17. In this case, a contact area between the first welding and/or soldering portions 14 and the interconnectors can be increased, which helps to lower the soldering resistance between the first welding and/or soldering portions 14 and the interconnectors and helps to improve the soldering adhesion between the first welding and/or soldering portions 14 and the interconnectors. In addition, a large composite area between the second welding and/or soldering portions 17 and the solar cell substrate 11 caused by a large width of the second welding and/or soldering portions 17 can be prevented, thereby ensuring high working reliability of the solar cell.

Specifically, when a width of the first welding and/or soldering portions is greater than a width of the second welding and/or soldering portions, and a difference between the two is determined based on an actual application scenario, and is not specifically limited herein.

In addition, as shown in FIG. 3 to FIG. 6, a length of the first welding and/or soldering portions 14 is equal to a length of the second welding and/or soldering portions 17. Certainly, a length of the first welding and/or soldering portions 14 is not equal to a length of the second welding and/or soldering portions 17. A length of the first welding and/or soldering portions 14 and a length of the second welding and/or soldering portions 17 affect sizes of effective contact with the interconnectors along the first direction. In addition, during actual manufacturing, due to a problem of device precision, placement positions of the interconnectors on the solar cell are offset. Therefore, along the first direction, when a length of the first welding and/or soldering portions 14 is equal to a length of the second welding and/or soldering portions 17, sizes of effective contact between the first welding and/or soldering portions 14 and the interconnectors and between the second welding and/or soldering portions 17 and the interconnectors along the first direction are approximately the same, thereby ensuring good contact between the interconnectors and the first welding and/or soldering portions 14 and between the interconnectors and the second welding and/or soldering portions 17.

In terms of a relative location relationship, as shown in FIG. 3 to FIG. 6, a side of the first welding and/or soldering portions 14 facing away from the bus electrode sections 13 is not connected to the collector electrodes 12 adjacent to the first welding and/or soldering portions 14 along the second direction and having a same conductivity type as the first welding and/or soldering portions 14. In this case, it is conducive to reducing a quantity of collector electrodes 12 electrically coupled to the first welding and/or soldering portions 14, so that the carriers collected by the collector electrodes 12 adjacent to a side of the first welding and/or soldering portions 14 facing away from the bus electrode sections 13 are directly transferred to the interconnectors, thereby helping to reduce a transmission loss of the carriers collected by the collector electrodes 12 adjacent to the side of the first welding and/or soldering portions 14 facing away from the bus electrode sections 13 to the interconnectors.

In addition, edges of a plurality of ones of the first welding and/or soldering portions close to a side of the bus electrode sections are flush or not flush. In this case, when edges of a plurality of ones of the first welding and/or soldering portions close to a side of the bus electrode sections are flush, it is conducive to enabling different first welding and/or soldering portions facing away from a side of the solar cell substrate to have a same surface area, and further conducive to enabling a large contact area between each first welding and/or soldering portion and the interconnector, thereby ensuring good electrical contact performance and stable mechanical connection performance between the first welding and/or soldering portions and the interconnectors. In addition, for beneficial effects obtained when edges of a plurality of ones of the first welding and/or soldering portions close to a side of the bus electrode sections are not flush, reference may be made to analysis on the beneficial effects of the foregoing description: spacings between ends of adjacent ones of the bus electrode sections with opposite conductivity types close to an edge of the solar cell substrate and the edge of the solar cell substrate are not equal. Details are not described herein again.

For example, when edges of a plurality of ones of the first welding and/or soldering portions close to a side of the bus electrode sections are flush, lengths of different bus electrode sections are not equal. However, when edges of a plurality of ones of the first welding and/or soldering portions close to a side of the bus electrode sections are not flush, lengths of different bus electrode sections are equal in some embodiments, to make total lengths, along the second direction, of structures formed by the first welding and/or soldering portions and the bus electrode sections in contact with the first welding and/or soldering portions approximately the same, so that currents collected by different first welding and/or soldering portions are the same, thereby helping to reduce a power loss.

In some cases, the solar cell further includes a first conductive material arranged on the first welding and/or soldering portions. In this case, in a process of connecting in series the solar cells provided in some embodiments of the present application to form a photovoltaic module, the interconnectors are soldered to the first welding and/or soldering portions by using a first conductive material, to ensure good soldering quality between the interconnectors and the first welding and/or soldering portions. A type of the first conductive material is determined with reference to the type of the second conductive material described above, and is not specifically limited herein.

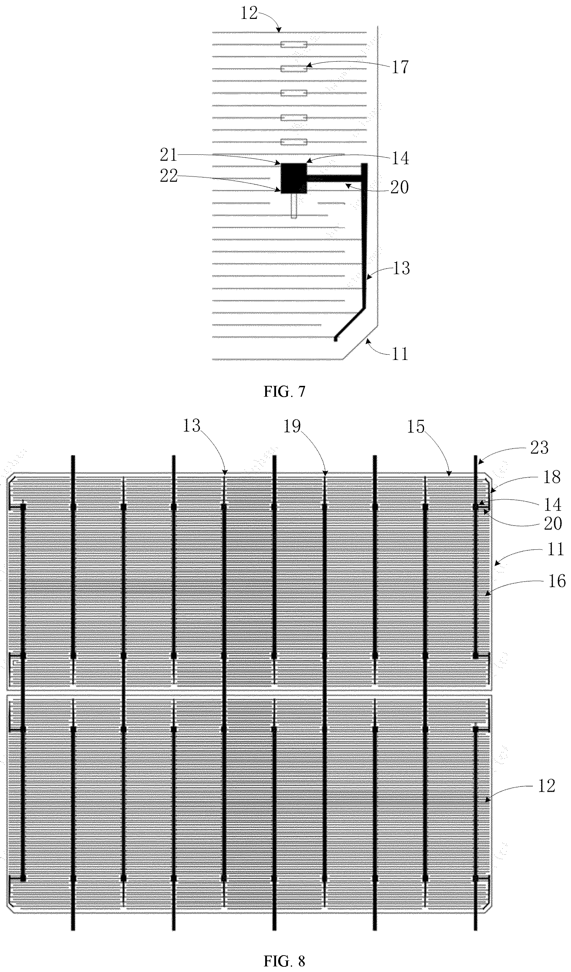

In addition, during an actual application, as shown in FIG. 3, FIG. 4, and FIG. 7, it is defined that the first welding and/or soldering portions 14 located on an outer side along the first direction each have a first end 21 and a second end 22 arranged oppositely along the second direction, and the second end 22 is closer to an edge of the solar cell substrate 11 along the second direction than the first end 21. In the foregoing case, a conductivity type of a collector electrode 12 adjacent to an outer side of the second end 22 is the same as a conductivity type of the first welding and/or soldering portion 14 located on the outer side. Alternatively, as shown in FIG. 7, a conductivity type of a collector electrode 12 adjacent to an outer side of the second end 22 is opposite to a conductivity type of the first welding and/or soldering portion 14 located on the outer side.

According to a second aspect, an embodiment of the present application provides a photovoltaic module. The photovoltaic module includes the solar cells according to the foregoing first aspect and various implementations thereof, and interconnectors configured to connect adjacent ones of the solar cells in series. The interconnectors are soldered to the first welding and/or soldering portions, and a terminal of the interconnector exceed the first welding and/or soldering portions.

In a possible implementation, the interconnectors and the bus electrode sections are in contact with each other or have gaps.

In a possible implementation, a ratio of a length by which the interconnectors exceed the first welding and/or soldering portions to a length of the bus electrode sections is greater than or equal to 5% and less than or equal to 20%.

When the foregoing technical solution is used, a ratio of a length by which an interconnector exceeds a first welding and/or soldering portion to a length of the bus electrode section falls within the foregoing range, which can prevent a small contact area between two ends of the interconnector along the second direction and the first welding and/or soldering portions due to a small value of the ratio, and ensure that the interconnector can come into contact with regions of a surface on a side of the first welding and/or soldering portion facing away from the solar cell substrate, thereby causing a small contact resistance between the two. In addition, carriers collected by collector electrodes between first welding and/or soldering portions and an edge of the solar cell substrate are conducted to the interconnectors through bus electrode sections and the first welding and/or soldering portions. Therefore, if the ratio falls within the foregoing range, it is further conducive to preventing a large value of the ratio from causing a large length of a portion that the interconnector does not need to extend and causing a large use amount of consumables. In addition, when the interconnector is in contact with the bus electrode section, it is further conducive to preventing a large value of the ratio from causing a large interconnection stress between the interconnector and the bus electrode section, thereby improving a yield of the solar cell.

In a possible implementation, a length by which the interconnectors exceed the first welding and/or soldering portions is less than or equal to 2 mm.

Some embodiments of the present application further provide a method for manufacturing a solar cell, and in particular, a method for forming an electrode structure. The manufacturing method is used to printing collector electrodes, bus electrode sections, connection portions (including the first welding and/or soldering portions and the second welding and/or soldering portions), and an insulation compound layer on a passivation layer of a solar cell substrate. The manufacturing method for a solar cell specifically includes the following steps:
Step 1: Print collector electrodes on a passivation layer provided on a solar cell substrate. In addition, low-temperature drying and shaping is performed at a temperature of 300°C to 400°C, to ensure that the formed collector electrodes are not deformed or damaged when bus electrode sections and connection portions are printed in a next step.
Step 2: Print bus electrode sections and connection portions. High-temperature sintering is performed on the collector electrodes, the bus electrode sections, and the connection portions simultaneously at a high temperature of 700°C to 800°C, so that the collector electrodes, the bus electrode sections, and the connection portions are melted and come into contact and fuse with each other, to form stable connections, and the collector electrodes are enabled connected to a corresponding doped semiconductor layer included in the solar cell substrate by penetrating through a passivation layer, to form a good ohmic contact. After the high-temperature sintering, a regions of the bus electrode sections and the connection portions can bear a larger pulling force, and have higher soldering stability. In this process, the regions of the bus electrode sections and the connection portions, in some embodiments, are in contact with or not in contact with the doped semiconductor layer.
Step 3: Print an insulation compound layer. Because the insulation compound layer cannot tolerate high-temperature sintering, the insulation compound layer is printed after the high-temperature sintering of the collector electrodes is completed. After the insulation compound layer is solidified at a temperature of 300°C to 400°C, the insulation compound layer is in sufficient contact with the collector electrodes and is adhered to the collector electrodes, to form an insulation layer firmly.

According to a third aspect, an embodiment of the present application provides a manufacturing method for a photovoltaic module. The manufacturing method for a photovoltaic module includes: first, providing the solar cells according to the foregoing first aspect and various implementations thereof; and then, connecting adjacent ones of the solar cells together in series by interconnectors using an infrared soldering process.

For beneficial effects of the second aspect and various implementations of the second aspect and the third aspect and various implementations of the third aspect in some embodiments of the present application, reference may be made to the analysis of the beneficial effects of the first aspect and various implementations of the first aspect, and details are not described herein again.

In the foregoing description, technical details such as composition and etching of each layer are not described in detail. However, a person skilled in the art should understand that a layer, a region, and the like of a required shape may be formed through various technical means. In addition, to form the same structure, a person skilled in the art may further design a method that is not the same as the method described above. In addition, although some embodiments are separately described above, this does not mean that the measures in some embodiments cannot be advantageously used in combination.

Some embodiments of the present disclosure are described above. However, some embodiments are merely for illustrative purposes and are not intended to limit the scope of the present disclosure. The scope of the present disclosure is defined by the appended claims and equivalents thereof. A person skilled in the art may make various substitutes and modifications without departing from the scope of the present disclosure, and the substitutes and modifications shall fall within the scope of the present disclosure.

## Claims

1. A solar cell, comprising: a solar cell substrate, collector electrodes, bus electrode sections, and a first welding and/or soldering portion,
at least one of a light receiving surface and a side facing away from light of the solar cell substrate being a target surface;
the collector electrodes and the bus electrode sections being arranged on the target surface of the solar cell substrate; the collector electrodes extending along a first direction, and different ones of the collector electrodes located on the same target surface being distributed at intervals along a second direction; the first direction being different from the second direction; the bus electrode sections being located in edge regions at two ends of the target surface along the second direction, and the bus electrode sections extending along the second direction; the bus electrode sections being electrically coupled to some of the collector electrodes having a same conductivity type as the bus electrode sections; and
the first welding and/or soldering portion being arranged on a side of the bus electrode sections facing away from an edge of the solar cell substrate along the second direction, and being electrically coupled to the corresponding bus electrode sections.

2. The solar cell according to claim 1, wherein a side of the first welding and/or soldering portions facing away from the bus electrode sections is not connected to the collector electrodes adjacent to the first welding and/or soldering portion along the second direction and having a same conductivity type as the first welding and/or soldering portions.

3. The solar cell according to claim 1, wherein different bus electrode sections located at a same end of the same target surface along the second direction are distributed at intervals along the first direction, the solar cell comprising two of the bus electrode sections arranged oppositely at different ends of the same target surface along the second direction, the two bus electrode sections arranged oppositely being not connected.

4. The solar cell according to claim 1, wherein a length of at least one of the bus electrode sections along the second direction is less than or equal to 10 mm; and/or
a ratio of a length of at least one of the bus electrode sections to a width of the solar cell substrate along the second direction is less than or equal to 12%; and/or
a width of at least one of the bus electrode sections along the first direction is greater than or equal to 10 µm and less than or equal to 500 µm; and/or
a width of at least one of the bus electrode sections gradually increases along a direction of approaching the first welding and/or soldering portion; and/or
a quantity of the bus electrode sections located at a same end of the same target surface along the second direction is greater than or equal to 6 and less than or equal to 30.

5. The solar cell according to claim 1, wherein a ratio of a quantity of the collector electrodes located in an edge region at an end of the target surface along the second direction to a total quantity of all the collector electrodes located on the target surface is less than or equal to 12%.

6. The solar cell according to claim 1, wherein the first welding and/or soldering portion and the bus electrode sections electrically coupled to the first welding and/or soldering portion are in an integrated structure; and/or
the solar cell further comprises a first conductive material arranged on the first welding and/or soldering portion.

7. The solar cell according to claim 1, wherein a length of the first welding and/or soldering portion along the first direction is greater than or equal to 100 µm and less than or equal to 10000 µm; and/or
a width of the first welding and/or soldering portion along the second direction is greater than or equal to 100 µm and less than or equal to 10000 µm.

8. The solar cell according to any one of claims 1 to 7, wherein in all the collector electrodes located on the same target surface, the collector electrodes electrically connected to the bus electrode sections are first-type collector electrodes, and the remaining collector electrodes are second-type collector electrodes; and
the solar cell further comprises second welding and/or soldering portion, the second welding and/or soldering portion being electrically coupled to at least one of the second-type collector electrodes.

9. The solar cell according to claim 8, wherein at least some of the second welding and/or soldering portions are arranged in parallel along the second direction; and/or
center lines of at least some of the second welding and/or soldering portions along the second direction are colinear with a center line of at least one of the bus electrode sections along the second direction.

10. The solar cell according to claim 8, wherein at least some of the second welding and/or soldering portions are arranged in parallel along the second direction, a gap being provided between one of the second welding and/or soldering portions and an adjacent another of the second welding and/or soldering portions along the second direction; and at least one of the collector electrodes being disconnected at the gap, or at least one of the collector electrodes continuously passing the gap.

11. The solar cell according to claim 8, wherein a length of the second welding and/or soldering portion along the first direction is greater than or equal to 100 µm and less than or equal to 10000 µm; and/or
a width of the second welding and/or soldering portion along the second direction is greater than or equal to 100 µm and less than or equal to 500 µm; and/or
a width of the first welding and/or soldering portion is greater than or equal to a width of the second welding and/or soldering portion; and/or
a length of the first welding and/or soldering portion is equal to a length of the second welding and/or soldering portion; and/or
the solar cell further comprises a second conductive material arranged on the second welding and/or soldering portion.

12. The solar cell according to any one of claims 1 to 7, wherein spacings between ends of adjacent ones of the bus electrode sections with opposite conductivity types close to an edge of the solar cell substrate and the edge of the solar cell substrate are not equal.

13. The solar cell according to any one of claims 1 to 7, wherein edges of a plurality of the first welding and/or soldering portions close to a side of the bus electrode sections are flush or not flush.

14. The solar cell according to any one of claims 1 to 7, wherein lengths of a plurality of ones of the bus electrode sections are equal or not equal.

15. The solar cell according to any one of claims 1 to 7, further comprising an edge bus electrode, the edge bus electrode being arranged at an end of the solar cell substrate along the first direction and extending along the second direction, a maximum width of the edge bus electrode being less than a maximum width of the bus electrode sections.

16. The solar cell according to claim 15, wherein the edge bus electrode is electrically coupled to at least some of the collector electrodes having a same conductivity type as the edge bus electrode, ends, along the first direction, of the collector electrodes electrically coupled to the edge bus electrode exceeding the edge bus electrode.

17. The solar cell according to any one of claims 1 to 7, further comprising a voltage test point, wherein the voltage test point is arranged on the bus electrode sections.

18. The solar cell according to any one of claims 1 to 7, wherein a distance by which an end of at least one of the bus electrode sections located at an edge of the solar cell substrate exceeds the collector electrodes electrically coupled to the at least one of the bus electrode sections and located at the edge of the solar cell substrate is greater than 0 mm and less than 0.12 mm.

19. The solar cell according to any one of claims 1 to 7, wherein the target surface is the back surface, in all the bus electrode sections located at a same end of the back surface along the second direction, two of the bus electrode sections located outermost along the first direction being first-type bus electrode sections, and the remaining bus electrode sections being second-type bus electrode sections, the first-type bus electrode sections being located on an outer side of an end of corresponding ones of the collector electrodes close to an edge of the solar cell substrate along the first direction, and the solar cell further comprising connection electrode sections, the first-type bus electrode sections being electrically coupled to corresponding ones of the first welding and/or soldering portions by the connection electrode sections.

20. The solar cell according to claim 19, wherein the solar cell is a back contact solar cell,
at least some of the collector electrodes located in the edge regions at the two ends of the target surface along the second direction being non-continuous collector electrodes, the non-continuous collector electrodes having a discontinuity for spacing apart the second-type bus electrode sections having a conductivity type opposite to that of the non-continuous collector electrodes, two ends of the non-continuous collector electrodes along the first direction being spaced apart by the first-type bus electrode sections having a conductivity type opposite to that of the non-continuous collector electrodes.

21. The solar cell according to claim 20, wherein the collector electrodes not electrically coupled to the bus electrode sections are disconnected and arranged at a portion between two corresponding ones of the first welding and/or soldering portions arranged oppositely; and/or
in all the collector electrodes located in the edge regions at the two ends of the target surface along the second direction, the collector electrodes located on an outer side are continuous collector electrodes, and the remaining collector electrodes are non-continuous collector electrodes.

22. The solar cell according to claim 20, wherein the non-continuous collector electrodes comprise a plurality of collector electrode sections distributed at intervals along the first direction,
when a width of at least one of the bus electrode sections gradually increases along a direction of approaching the first welding and/or soldering portions, corresponding different pairs of the collector electrode sections having a conductivity type opposite to that of the same bus electrode section corresponding to different spacings, the pairs of the collector electrode sections each being two adjacent ones of the collector electrode sections comprised by the same collector electrode.

23. The solar cell according to any one of claims 1 to 7, wherein an end of at least one of the bus electrode sections close to an edge region of the target surface along the second direction extends to a side, close to the edge region of the target surface along the second direction, of a corresponding one of the collector electrodes electrically coupled to the bus electrode section; and/or
an end of the bus electrode sections close to the first welding and/or soldering portions is flush with an end of the first welding and/or soldering portions close to the bus electrode sections; or an end of the bus electrode sections close to the first welding and/or soldering portions extends to a portion on a side of the first welding and/or soldering portions facing away from the solar cell substrate.

24. A photovoltaic module, comprising:
the solar cells according to any one of claims 1 to 23; and
interconnectors configured to connect adjacent ones of the solar cells together in series, the interconnectors being soldered to the first welding and/or soldering portion, terminals of the interconnectors exceeding the first welding and/or soldering portion.

25. The photovoltaic module according to claim 24, wherein a ratio of a length by which the interconnectors exceed the first welding and/or soldering portion to a length of the bus electrode sections is greater than or equal to 5% and less than or equal to 20%; or
a length by which the bus electrode sections exceed the first welding and/or soldering portion is less than or equal to 2 mm.

26. The photovoltaic module according to claim 24 or 25, wherein the interconnectors and the bus electrode sections are in contact with each other or have gaps.

27. A method for manufacturing a photovoltaic module, comprising:
providing the solar cells according to any one of claims 1 to 23; and
connecting adjacent ones of the solar cells together in series by interconnectors using an infrared soldering process.
